(19) Europäisches Patentamt
European Patent Office
Office européen des brevets

(11) **EP 4 577 001 A1**

(12) **EUROPEAN PATENT APPLICATION**

(43) Date of publication:
**25.06.2025 Bulletin 2025/26**

(21) Application number: **24216061.2**

(22) Date of filing: **28.11.2024**

(51) International Patent Classification (IPC):
*H10F 39/15* (2025.01)   *H10F 39/18* (2025.01)
*H10F 39/00* (2025.01)   *H04N 25/704* (2023.01)

(52) Cooperative Patent Classification (CPC):
**H10F 39/151; H04N 25/704; H10F 39/182;
H10F 39/8023; H10F 39/8053; H10F 39/813**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.12.2023 KR 20230188858
20.03.2024 KR 20240038747**

(71) Applicant: **Samsung Electronics Co., Ltd.
Suwon-si, Gyeonggi-do 16677 (KR)**

(72) Inventor: **LEE, Seungjoon
16677 Suwon-si, Gyeonggi-do (KR)**

(74) Representative: **Kuhnen & Wacker
Patent- und Rechtsanwaltsbüro PartG mbB
Prinz-Ludwig-Straße 40A
85354 Freising (DE)**

(54) **IMAGE SENSOR**

(57)     An image sensor is provided. The image sensor includes: a first substrate including a first surface and a second surface opposite each other, and a plurality of photoelectric conversion elements (PD1-PD12) between the first surface and the second surface; and a color filter provided on the second surface of the first substrate and including a first color filter (303G), a second color filter (303R), and a third color filter (303B). The first color filter (303G) is provided on 36 photoelectric conversion elements among the plurality of photoelectric conversion elements (PD1-PD12). The 36 photoelectric conversion elements are arranged in six columns extending in a first direction (X) and in six rows extending in a second direction (Y) that crosses the first direction (X). Floating diffusion regions (FD) of 12 photoelectric conversion elements among the 36 photoelectric conversion elements are connected to each other.

FIG. 5

EP 4 577 001 A1

**Description**

BACKGROUND

1. Field

The present disclosure relates to an image sensor.

2. Description of Related Art

An image sensor is a semiconductor device that converts an optical image into an electrical signal. Image sensors can be classified as, for example, a silicon semiconductor-based charge coupled device (CCD) type image sensor or a complementary metal oxide semiconductor (CMOS) type image sensor (CIS).

A CMOS-type image sensor has a simple driving method and can an integrate signal processing circuit on a single chip, enabling miniaturization and low power consumption, so they can be applied to products with limited battery capacity. With the advancement of the electronics industry, various research efforts are ongoing to enhance the performance of a CMOS image sensor.

SUMMARY

According to an aspect of an example embodiment, an image sensor includes: a first substrate including a first surface and a second surface opposite each other, and a plurality of photoelectric conversion elements between the first surface and the second surface; a color filter provided on the second surface of the first substrate and including a first color filter, a second color filter, and a third color filter. The first color filter is provided on 36 photoelectric conversion elements among the plurality of photoelectric conversion elements. The 36 photoelectric conversion elements are arranged in six columns extending in a first direction and in six rows extending in a second direction that crosses the first direction Floating diffusion regions of 12 photoelectric conversion elements among the 36 photoelectric conversion elements are connected to each other.

According to another aspect of an example embodiment, an image sensor including: a substrate including a first surface and a second surface opposite each other, and a plurality of photoelectric conversion elements between the first surface and the second surface; and a color filter provided on the second surface of the substrate and including a first color filter, a second color filter, a third color filter and a fourth color filter, the first color filter and the fourth color filter corresponding to a common color. A first color region of the image sensor includes the first color filter, 36 photoelectric conversion elements, among the plurality of photoelectric conversion elements, are grouped into three groups, each of the three groups including 12 photoelectric conversion elements arranged in six columns extending in a first direction and two rows extending in a second direction, wherein for each of the three groups, floating diffusion regions of the 12 photoelectric conversion elements are configured to be commonly connected. A second color region of the image sensor includes the second color filter, 36 photoelectric conversion elements, among the plurality of photoelectric conversion elements, are grouped into three groups, each of the three groups including 12 photoelectric conversion elements arranged in six columns extending in the first direction and two rows extending in the second direction, wherein for each of the three groups, floating diffusion regions of the 12 photoelectric conversion elements are configured to be commonly connected. A third color region of the image sensor includes the third color filter is provided on 36 photoelectric conversion elements, among the plurality of photoelectric conversion elements, are grouped into three groups, each of the three groups including 12 photoelectric conversion elements arranged in six columns extending in the first direction and two rows extending in the second direction, wherein for each of the three groups, floating diffusion regions of the 12 photoelectric conversion elements are configured to be commonly connected. A fourth color region of the image sensor includes the fourth color filter is provided on 36 photoelectric conversion elements, among the plurality of photoelectric conversion elements, are grouped into three groups, each of the three groups including 12 photoelectric conversion elements arranged in six columns extending in the first direction and two rows extending in the second direction, wherein for each of the three groups, floating diffusion regions of the 12 photoelectric conversion elements are configured to be commonly connected.

According to another aspect of an example embodiment, an image sensor including: a substrate including a first surface and a second surface opposite each other, and a plurality of photoelectric conversion elements between the first surface and the second surface; and a color filter provided on the second surface of the substrate and including a first color filter, a second color filter, and a third color filter. The first color filter is provided on 36 photoelectric conversion elements among the plurality of photoelectric conversion elements. The 36 photoelectric conversion elements are arranged in six columns extending in a first direction and in six rows extending in a second direction that crosses the first direction. Floating diffusion regions of nine photoelectric conversion elements among the 36 photoelectric conversion elements are connected to each other.

BRIEF DESCRIPTION OF DRAWINGS

The above and other aspects and features will be more apparent from the following description of example embodiments with reference to the attached drawings, in which:

FIG. 1 is a block diagram of an image sensor according to an example embodiment;
FIG. 2 is a plan view illustrating an image sensor according to an example embodiment;
FIG. 3 is a cross-sectional view taken along the line A-A' of FIG. 2 according to an example embodiment;
FIG. 4 is an enlarged view of a portion marked with B in FIG. 3 according to an example embodiment;
FIG. 5 illustrates a plurality of photoelectric conversion elements and a microlens in the image sensor according to an example embodiment;
FIG. 6 illustrates the same region as FIG. 5 for another example embodiment;
FIG. 7 illustrates the same region as FIG. 5 for another example embodiment;
FIG. 8 illustrates the same region as FIG. 5 for another example embodiment;
FIG. 9 illustrates the same region as FIG. 5 for another example embodiment;
FIG. 10 illustrates the same region as FIG. 5 for another example embodiment;
FIG. 11 is a cross-sectional view taken along the line A-A of FIG. 10 according to an example embodiment;
FIG. 12 is a cross-sectional view taken along the line B-B' of FIG. 10 according to an example embodiment;
FIG. 13 illustrates the same region as FIG. 10 for another example embodiment;
FIG. 14 is a cross-sectional view taken along the line C-C' of FIG. 13;
FIG. 15 illustrates the same region as FIG. 10 for another example embodiment;
FIG. 16 is a cross-sectional view taken along the line D-D' of FIG. 15;
FIG. 17 is a circuit diagram of a pixel included in an image sensor according to example embodiments;
FIG. 18 is a circuit diagram of a pixel included in an image sensor according to another example embodiment;
FIG. 19 is a circuit diagram of a pixel included in an image sensor according to another example embodiment;
FIG. 20 is a circuit diagram of a pixel included in an image sensor according to another example embodiment;
FIG. 21 illustrates the same region as FIG. 5 for another example embodiment;
FIG. 22 is a plan view illustrating nine photoelectric conversion elements in an image sensor according to an example embodiment;
FIG. 23 is a cross-sectional view taken along the line E-E' of FIG. 22 according to an example embodiment;
FIG. 24 is a circuit diagram of a pixel included in an image sensor according to an example embodiment;
FIG. 25 is a circuit diagram of a pixel included in an image sensor according to another example embodiment and
FIG. 26 is a cross-sectional view of an image sensor according to an example embodiment.

DETAILED DESCRIPTION

Example embodiments will be described more fully hereinafter with reference to the accompanying drawings. As those skilled in the art would realize, example embodiments described herein may be modified in different various ways. Like components are denoted by like reference numerals throughout the specification, and repeated descriptions thereof are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Each example embodiment provided in the following description is not excluded from being associated with one or more features of another example or another example embodiment also provided herein or not provided herein but consistent with the present disclosure.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element, or intervening elements may also be present. In contrast, when an element is referred to as being "directly on" another element, there are no intervening elements present.

Hereinafter, a semiconductor device and an electronic system according to an example embodiment of the present disclosure will be described in detail with reference to the drawings.

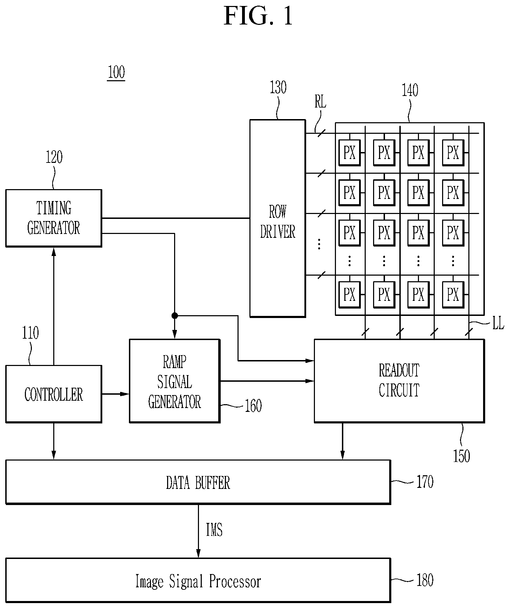

FIG. 1 is a block diagram of an image sensor according to an example embodiment.

Referring to FIG. 1, an image sensor 100 according to an example embodiment may include a controller (i.e., a control circuit) 110, a timing generator (i.e., a timing generation circuit) 120, a row driver (i.e., a row driving circuit) 130, a pixel array 140, a readout circuit 150, a ramp signal generator (i.e., a ramp signal generation circuit) 160, a data buffer 170, and an image signal processor 180. In an example embodiment, the image signal processor 180 may be provided outside of the image sensor 100.

The image sensor 100 may generate an image signal by converting light received from the outside into an electrical signal. The image signal IMS may be provided to the image signal processor 180.

The image sensor 100 may be mounted on an electronic device that has the function of sensing images or light. For example, the image sensor 100 may be mounted on electronic devices such as cameras, smartphones, wearable devices, Internet of Things (IoT) devices, home appliances, personal computers, personal digital assistants (PDAs), portable multimedia players (PMPs), navigations, drones, and advanced driver assistance systems (ADAS). Alternatively, the image sensor 100 may be mounted on an electronic device provided as a component in a vehicle, furniture, manufacturing facilities, doors, and various measuring devices.

The controller 110 may generally control each of the components 120, 130, 150, 160 and 170 included in the image sensor 100. The controller 110 may control the operation timing of each of the components 120, 130, 150, 160 and 170 using control signals. In an example embodiment, the controller 110 may receive a mode signal indicating an imaging mode from an application processor and may generally control the image sensor 100 based on the received mode signal. For example, the application processor may determine the imaging mode of the image sensor 100 according to various scenarios such as the illuminance of the imaging environment, the user's resolution setting, and the sensed or learned state, and provide the determined result to the controller 110 as a mode signal. The controller 110 may control a plurality of pixels of the pixel array 140 to output a pixel signal according to an imaging mode, the pixel array 140 may output a pixel signal for each of the plurality of pixels or a pixel signal for some of the plurality of pixels, and the readout circuit 150 may sample and process pixel signals received from the pixel array 140. The timing generator 120 may generate a signal that is a reference of the operation timing of the components of the image sensor 100. The timing generator 120 may control the timing of the row driver 130, the readout circuit 150, and the ramp signal generator 160. The timing generator 120 may provide a control signal for controlling the timing of the row driver 130, the readout circuit 150, and the ramp signal generator 160.

The pixel array 140 may include a plurality of pixels PX, a plurality of row lines RL and a plurality of column lines LL respectively connected to the plurality of pixels PX. In an example embodiment, each pixel PX may include at least one or more photoelectric conversion elements. The photoelectric conversion element may detect incident light and convert the incident light into an electrical signal according to the amount of light, that is, a plurality of analog pixel signals. The photoelectric conversion element may be a photodiode, a pinned diode, or the like. In addition, the photoelectric conversion element may be a single-photon avalanche diode (SPAD) applied to a 3D sensor pixel. The level of the analog pixel signal output from the photoelectric conversion element may be proportional to the amount of charge output from the photoelectric conversion element. That is, the level of the analog pixel signal output from the photoelectric conversion element may be determined according to the amount of light received into the pixel array 140.

A plurality of row lines RL may extend in a first direction and may be connected to pixels PX disposed in the first direction. For example, a control signal output from the row driver 130 to the row line RL may be transmitted to the gates of the transistors of the plurality of pixels PX connected to the row line RL. The column line LL may extend in a second direction crossing the first direction and may be connected to pixels PX disposed along the second direction. A plurality of pixel signals output from the plurality of pixels PX may be transmitted to the readout circuit 150 through the plurality of column lines LL.

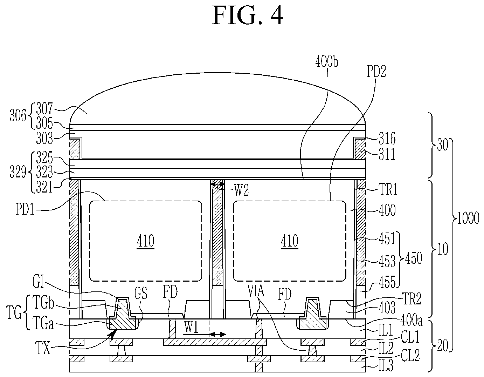

A color filter layer and a microlens layer may be provided on the pixel array 140. The microlens layer may include a plurality of microlenses, and each of the plurality of microlenses may be provided above at least one corresponding pixel PX. The color filter layer may include color filters such as red, green, and blue, and may further include a white filter. For one pixel PX, a color filter of one color may be provided between the pixel PX and the corresponding microlens. A specific structure of the color filter layer and the microlens layer will be described later in FIG. 4.

The row driver 130 may generate a control signal for driving the pixel array 140 in response to the control signal of the timing generator 120 and provide a control signal to the plurality of pixels PX of the pixel array 140 through the plurality of row lines RL. In an example embodiment, the row driver 130 may control to detect light incident on the pixel PX in units of the row line. The row line unit may include at least one row line RL. For example, the row driver 130 may provide a transmission signal, a reset signal, a selection signal, or the like to the pixel array 140.

In response to a control signal from the timing generator 120, the readout circuit 150 may convert a pixel signal (or an electrical signal) from pixels PX connected to a row line RL selected from among a plurality of pixels PX into a pixel value representing the amount of light. The readout circuit 150 may convert a pixel signal output through a corresponding column line LL into a pixel value. For example, the readout circuit 150 may convert the pixel signal into a pixel value by comparing the ramp signal with the pixel signal. The pixel value may be image data having a plurality of bits. Specifically, the readout circuit 150 may include a selector, a plurality of comparators, a plurality of counter circuits, and the like.

The ramp signal generator 160 may generate a reference signal and transmit the reference signal to the readout circuit 150.

The ramp signal generator 160 may include a current source, a resistor, and a capacitor. The ramp signal generator 160 may generate a plurality of ramp signals that fall or rise at a slope determined according to the current magnitude of the variable current source or the resistance value of the variable resistor by adjusting the current magnitude of a variable current source or the resistance value of a variable resistor to adjust the ramp voltage, which is the voltage across the ramp resistor.

The data buffer 170 may store pixel values of a plurality of pixels PX connected to the selected column line LL transmitted from the readout circuit 150 and output the stored pixel values in response to the enable signal from the controller 110.

The image signal processor 180 may perform image signal processing on the image signal received from the data buffer 170. For example, the image signal processor 180 may receive a plurality of image signals from the data buffer 170 and synthesize the received image signals to generate a single image.

In an example embodiment, a plurality of pixels may be grouped together in an M*N (M, N is an integer of 2 or more) form to form one unit pixel group. The M*N form may be a form in which M number are arranged in the arrangement direction of the column lines LL and N number are arranged in the arrangement direction of the row lines RL. For example, one unit pixel group may include a plurality of pixels arranged in a 2*6 form, and one unit pixel group may output one analog pixel signal. The following configuration is not limited to one pixel but may also be applied to the unit pixel group.

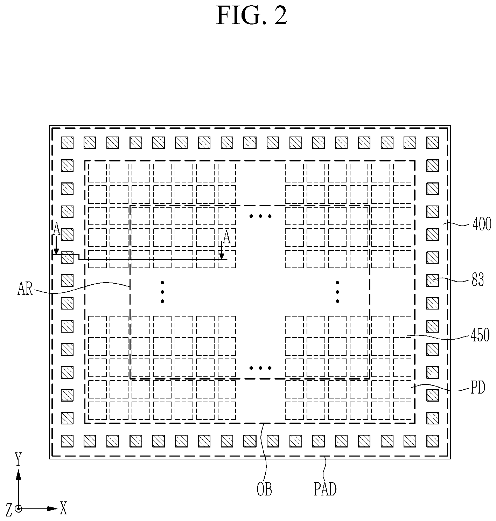

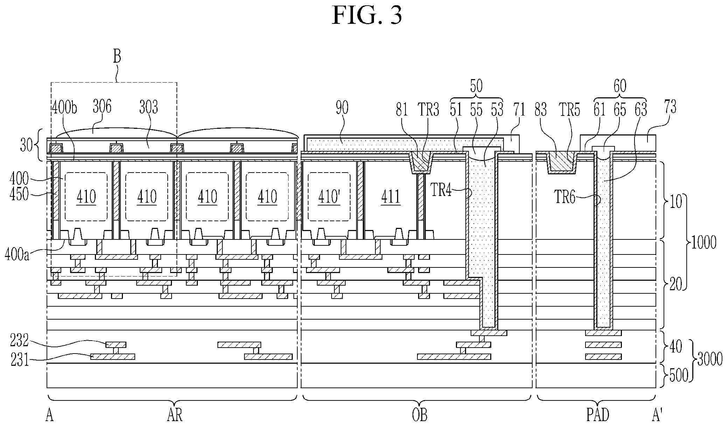

FIG. 2 is a plan view illustrating an image sensor according to an example embodiment of the present disclosure. FIG. 3 is a cross-sectional view taken along the line A-A' of FIG. 2. FIG. 4 is an enlarged view of a portion marked with B in FIG. 3.

Referring to FIG. 2 to FIG. 4, the image sensor according to an example embodiment may include a first chip 1000 and a third chip 3000. The first chip 1000 may include a photoelectric conversion layer 10, a first wire region 20, and a light transmission layer 30. The photoelectric conversion layer 10 may include a first substrate 400, a pixel separation pattern 450, and a photoelectric conversion region 410 provided in the first substrate 400. Light incident from the outside may be converted into an electrical signal in the photoelectric conversion region 410.

Referring to FIG. 2, the first substrate 400 may include a pixel array region AR, an optical black region OB, and a pad region PAD on a plane. The pixel array region AR may be provided in a central region of the first substrate 400 on a plane. The pixel array region AR may include a plurality of pixels PX. The pixel PX may output a photoelectric signal from incident light. The pixels PX may be disposed along a row parallel to the first direction X and a column parallel to the second direction Y.

The pad region PAD may be provided at an edge portion of the first substrate 400 and may surround the pixel array region AR. A plurality of pad terminals 83 may be provided in the pad region PAD. The pad terminals 83 may provide an electrical signal generated in the pixel PX to the outside. Alternatively, an external electrical signal or voltage may be transmitted to the pixel PX through the pad terminal 83. Because the pad region PAD is provided at the edge portion of the first substrate 400, the pad terminal 83 may be easily connected to the outside.

The optical black region OB may be provided between the pixel array region AR and the pad region PAD of the first substrate 400. The optical black region OB may surround the pixel array region AR. The optical black region OB may include a plurality of dummy regions 411. The signal generated in the dummy region 411 may be used as information for removing process noise.

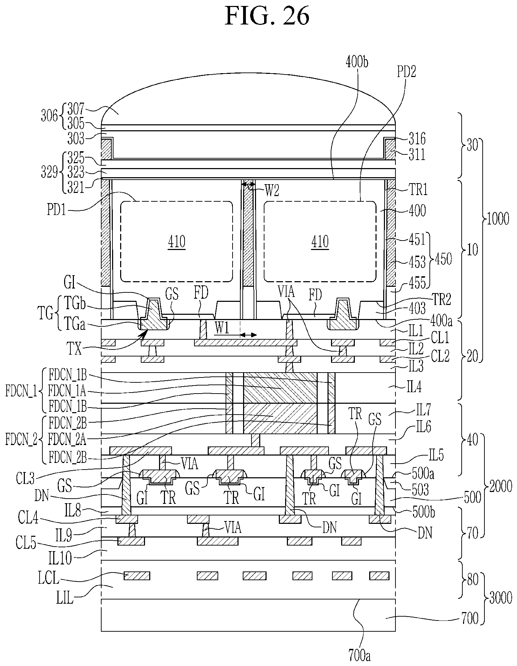

Referring to FIG. 3 to FIG. 4, the image sensor may include a photoelectric conversion layer 10, a gate electrode TG of a transfer transistor, a first wire region 20, and a light transmission layer 30. The photoelectric conversion layer 10 may include a first substrate 400 and a pixel separation pattern 450. One or more gate electrodes of a plurality of other transistors, such as a conversion transistor, a source follower transistor, and a selection transistor, may be provided on the same layer as the gate electrode TG of the transfer transistor. However, this is an example, and according to example embodiments, one or more gate electrodes of a conversion transistor, a source follower transistor, and a selection transistor may be provided on a different substrate from the gate electrode TG of the transfer transistor and may be electrically connected to each other. This will be described later separately with reference to FIG. 26.

In FIG. 3, the pixel array region AR may include a plurality of pixels PX. The description of the pixel array region AR will later be described with reference to FIG. 4, and hereinafter, the optical black region OB and the pad region PAD will be described with reference to FIG. 3.

A first connection structure 50, a first pad terminal 81, and a bulk color filter 90 may be provided on the first substrate 400 in the optical black region OB. The first connection structure 50 may include a first light blocking pattern 51, a first insulating pattern 53, and a first capping pattern 55. The first light blocking pattern 51 may be provided on the second surface 400b of the first substrate 400. The first light blocking pattern 51 may cover inner walls of the third trench TR3 and the fourth trench TR4. The first light blocking pattern 51 may penetrate the photoelectric conversion layer 10 and the first wire region 20 to electrically connect the photoelectric conversion layer 10 and the first wire region 20. More specifically, the first light blocking pattern 51 may be in contact with the wire in the first wire region 20 and the pixel separation pattern 450 in the photoelectric conversion layer 10. Accordingly, the first connection structure 50 may be electrically connected to wires in the first wire region 20. The first light blocking pattern 51 may include a metal material, for example, tungsten. The first light blocking pattern 51 may block light incident into the optical black region OB.

The first pad terminal 81 may be provided inside the third trench TR3 to fill the remaining portion of the third trench TR3. The first pad terminal 81 may include a metal material, for example, aluminum. The first pad terminal 81 may be connected to the pixel separation pattern 450. Accordingly, a negative voltage may be applied to the pixel separation pattern 450 through the first pad terminal 81.

The first insulating pattern 53 may be provided on the first light blocking pattern 51 to fill the remaining portion of the fourth trench TR4. The first insulating pattern 53 may penetrate the photoelectric conversion layer 10 and the first wire region 20. The first capping pattern 55 may be provided on the first insulating pattern 53. The first capping pattern 55 may be provided on the first insulating pattern 53.

The bulk color filter 90 may be provided on the first pad terminal 81, the first light blocking pattern 51, and the first capping pattern 55. The bulk color filter 90 may cover the first pad terminal 81, the first light blocking pattern 51, and the first capping pattern 55. The first passivation layer 71 may be provided on the bulk color filter 90 to cover the bulk color filter 90.

A photoelectric conversion region 410' and a dummy region 411 may be provided in the optical black region OB of the first substrate 400. The photoelectric conversion region 410' may be doped with, for example, impurities of a second conductivity type different from the first conductivity type. The second conductivity type may be, for example, an n-type. The photoelectric conversion region 410' has a similar structure to the photoelectric conversion region 410, which will be described later with reference to FIG. 4, but may not perform an operation of receiving light and generating an electrical signal. The dummy region 411 may be a region that is not doped with an impurity. The signals generated in the photoelectric conversion region 410' and the dummy region 411 may be used as information for removing process noise thereafter.

In the pad region PAD, a second connection structure 60, a second pad terminal 83, and a second passivation layer 73 may be provided on the first substrate 400. The second connection structure 60 may include a second light blocking pattern 61, a second insulating pattern 63, and a second capping pattern 65.

The second light blocking pattern 61 may be provided on the second surface 400b of the first substrate 400. More specifically, the second light blocking pattern 61 may cover inner walls of the fifth trench TR5 and the sixth trench TR6. The second light blocking pattern 61 may penetrate portions of the photoelectric conversion layer 10, the first wire region 20, and the second wire region 40. More specifically, the second light blocking pattern 61 may be in contact with the wires 231 and 232 in the second wire region 40. The second light blocking pattern 61 may include a metallic material, for example, tungsten.

The second pad terminal 83 may be provided inside the fifth trench TR5. The second pad terminal 83 may be provided on the second light blocking pattern 61 to fill the remaining portion of the fifth trench TR5. The second pad terminal 83 may include a metallic material, for example, aluminum. The second pad terminal 83 may serve as an electrical connection path between the image sensor element and the outside. The second insulating pattern 63 may fill the remaining portion of the sixth trench TR6. The second insulating pattern 63 may completely or partially penetrate the photoelectric conversion layer 10 and the first wire region 20. A second capping pattern 65 may be provided on the second insulating pattern 63. The second passivation layer 73 may cover a portion of the second light blocking pattern 61 and the second capping pattern 65.

The current applied through the second pad terminal 83 may flow to the pixel separation pattern 450 through the second light blocking pattern 61, the wires 231 and 232 in the second wire region 40, and the first light blocking pattern 51. Electrical signals generated from the photoelectric conversion regions 410 and 410' and the dummy region 411 may be transmitted to the outside through wires of the first wire region 20, wires 231 and 232 in the second wire region 40, the second light blocking pattern 61, and the second pad terminal 83.

In FIG. 3, a configuration in which the first pad terminal 81 and the second pad terminal 83 are provided on the second surface 400b is illustrated, but this is only an example, and the first pad terminal 81 and the second pad terminal 83 may be provided on the opposite surface of the second surface 400b, that is, on the first surface 400a or a region below the first surface 400b.

Hereinafter, the first chip 1000 of the pixel array region AR will be described with reference to FIG. 4. The first chip 1000 includes a first substrate 400. The first substrate 400 may include a first surface 400a and a second surface 400b opposite each other. Light may be incident on the second surface 400b of the first substrate 400. The first wire region 20 may be provided on the first surface 400a of the first substrate 400, and the light transmission layer 30 may be provided on the second surface 400b of the first substrate 400. The first substrate 400 may be a semiconductor substrate or a silicon-on-insulator (SOI) substrate. For example, the semiconductor substrate may include, for example, a silicon substrate, a germanium substrate, or a silicon-germanium substrate. The first substrate 400 may include a first conductivity type impurity. For example, the first conductivity type impurities may be a p-type impurity such as aluminum (Al), boron (B), indium (In), or gallium (Ga).

Referring to FIG. 2 as well as FIG. 4, the first substrate 400 may include a plurality of photoelectric conversion elements PD defined by a pixel separation pattern 450. A plurality of photoelectric conversion elements PD may be arranged in a matrix form along a first direction X and a second direction Y crossing each other. Hereinafter, as described in detail, one pixel circuit may be configured by connecting the floating diffusion regions FD of the plurality of photoelectric conversion elements PD each other. For example, floating diffusion regions FD of 12 photoelectric conversion elements PD may be connected to each other, or floating diffusion regions FD of nine photoelectric conversion elements PD may be connected to each other, and specific connections will be described later.

The photoelectric conversion region 410 may generate and accumulate electric charges according to the amount of received light. The photoelectric conversion region 410 may constitute a photoelectric conversion element PD, and the first photoelectric conversion element PD1 and the second photoelectric conversion element PD2 are shown in FIG. 4.

The photoelectric conversion region 410 may be a region doped with impurity of a second conductivity type in the first substrate 400. The second conductivity type impurity may have a conductivity type opposite to the first conductivity type impurity. The second conductivity type impurities may include n-type impurities such as phosphorus, arsenic, bismuth, or antimony. For example, each photoelectric conversion region 410 may include a first region adjacent to the first surface 400a and a second region adjacent to the second surface 400b. There may be a difference in impurity concentration between the first region and the second region of the photoelectric conversion region 410. Accordingly, the photoelectric conversion region 410 may have a potential slope between the first surface 400a and the second surface 400b of the first substrate 400. As another example, the photoelectric conversion region 410 may not have a potential gradient between the first surface 400a and the second surface 400b of the first substrate 400.

The first substrate 400 and the photoelectric conversion region 410 may constitute a photodiode. That is, a photodiode may be configured by a p-n junction between the first substrate 400 of the first conductivity type and the photoelectric conversion region 410 of the second conductivity type. The photoelectric conversion region 410 constituting the photodiode may generate and accumulate photo charges in proportion to the intensity of incident light.

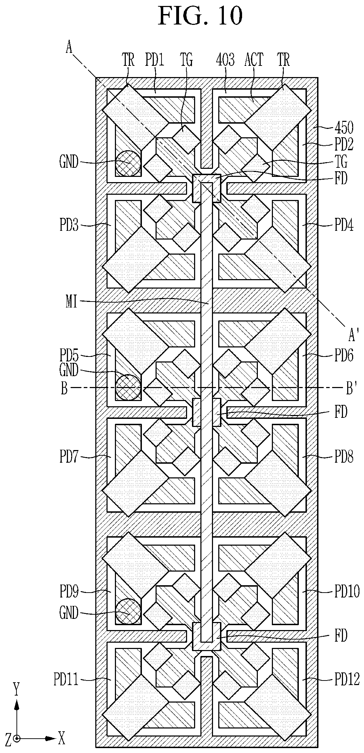

Referring to FIG. 3 and FIG. 4, a pixel separation pattern 450 may be provided in the first substrate 400. When viewed in a plan view, the pixel separation pattern 450 may have a grid structure in a plan view. As illustrated in FIG. 2, a pixel separation pattern 450 may be provided in a grid shape in a region between pixels PX. That is, the pixel separation pattern 450 may surround each pixel PX. However, the shape of the pixel separation pattern 450 is an example but example embodiments are not limited thereto. The planar shapes of the various pixel separation patterns 450 will be described later in detail with reference to FIG. 10, FIG. 13, FIG. 15, and FIG. 22.

Referring to FIG. 3 and FIG. 4, the pixel separation pattern 450 may be provided in the first trench TR1 and the second trench TR2. Referring to FIG. 4, the first trench TR1 and the second trench TR2 may be recessed from the first surface 400a of the first substrate 400. The first trench TR1 may penetrate the first substrate 400, and the second trench TR2 may not penetrate the first substrate 400. That is, the depth of the first trench TR1 may be deeper than the depth of the second trench TR2.

The pixel separation pattern 450 may extend from the first surface 400a of the first substrate 400 toward the second surface 400b. The pixel separation pattern 450 may be a deep trench isolation (DTI) layer. The pixel separation pattern 450 may penetrate the first substrate 400. A vertical height of the pixel separation pattern 450 may be substantially the same as a vertical thickness of the first substrate 400. However, this is only an example, and the vertical height of the pixel separation pattern 450 may not be the same as the vertical thickness of the first substrate 400. That is, the vertical height of the pixel separation pattern 450 may be lower than the vertical thickness of the first substrate 400.

For example, the width of the pixel separation pattern 450 may gradually decrease from the first surface 400a of the first substrate 400 toward the second surface 400b. The width on the first surface 400a of the pixel separation pattern 450 may be a first width W1, and the width on the second surface 400b of the pixel separation pattern 450 may be a second width W2. That is, the first width W1 may be greater than the second width W2.

The pixel separation pattern 450 may include a first separation pattern 451, a second separation pattern 453, and a capping pattern 455. The first separation pattern 451 may be provided along a sidewall of the first trench TR1. The first separation pattern 451 may include, for example, a silicon-based insulating material (e.g., silicon nitride, silicon oxide, or silicon oxynitride) or a high-k material (e.g., hafnium oxide or aluminum oxide). As another example, the first separation pattern 451 may include a plurality of layers, and each of the layers may include a different material. The first separation pattern 451 may have a refractive index lower than that of the first substrate 400. Accordingly, a crosstalk phenomenon between the pixels PX on the first substrate 400 may be prevented or reduced.

The second separation pattern 453 may be provided in the first separation pattern 451. For example, a sidewall of the second separation pattern 453 may be surrounded by the first separation pattern 451. The first separation pattern 451 may be provided between the second separation pattern 453 and the first substrate 400. The second separation pattern 453 may be spaced apart from the first substrate 400 by the first separation pattern 451. Accordingly, during the operation of the image sensor, the second separation pattern 453 may be electrically separated from the first substrate 400. The second separation pattern 453 may include a crystalline semiconductor material, for example, polycrystalline silicon. For example, the second separation pattern 453 may further include a dopant, and the dopant may include a first conductivity type impurity or a second conductivity type impurity.

For example, the second separation pattern 453 may include a doped polycrystalline silicon. Alternatively, the second separation pattern 453 may include an undoped crystalline semiconductor material. For example, the second separation pattern 453 may include an undoped polycrystalline silicon. The term "undoped" may mean not performing an intentional doping process. The dopant may include an n-type dopant and a p-type dopant.

The capping pattern 455 may be provided on the lower surface of the second separation pattern 453. The capping pattern 455 may be disposed adjacent to the first surface 400a of the first substrate 400. The upper surface of the capping pattern 455 and the lower surface of the second separation pattern 453 may be provided at substantially similar levels. The capping pattern 455 may include a non-conductive material. For example, the capping pattern 455 may include a silicon-based insulating material (e.g., silicon nitride, silicon oxide, or silicon oxynitride) or a high-k material (e.g., hafnium oxide or aluminum oxide). Accordingly, the pixel separation pattern 450 may prevent photo charges generated by incident light incident on the pixel PX from entering another adjacent pixel PX by random drift. That is, the pixel separation pattern 450 may prevent crosstalk phenomenon between pixels PX.

The device separation pattern 403 may be provided in the first substrate 400. For example, the device separation pattern 403 may be provided within the second trench TR2. The second trench TR2 may be recessed from the first surface 400a of the first substrate 400. The device separation pattern 403 may be a shallow trench isolation (STI) layer. The device separation pattern 403 may define an active region. An upper surface of the device separation pattern 403 may be provided in the first substrate 400. The width of the device separation pattern 403 may gradually decrease from the first surface 400a to the second surface 400b of the first substrate 400. An upper surface of the device separation pattern 403 may be vertically spaced apart from the photoelectric conversion region 410. The device separation pattern 403 may include silicon nitride, silicon oxide, or silicon oxynitride. The device separation pattern 403 may include the same material as the first separation pattern 451 of the pixel separation pattern 450, and in this case, the boundary between the device separation pattern 403 and the first separation pattern 451 may not be visually recognized. However, this is only an example, example embodiments are not limited thereto.

In addition, FIG. 4 shows a configuration in which the device separation pattern 403, the pixel separation pattern 450, and the first surface 400a of the first substrate 400 are provided on the same plane, but this is only an example, and example embodiment are not limited thereto. For example, the device separation pattern 403, the pixel separation pattern 450, and the first surface 400a of the first substrate 400 may not be coplanar. The device separation pattern 403 and the pixel separation pattern 450 may protrude from or be recessed from the first surface 400a of the first substrate 400.

The transfer transistor TX may be provided on an active region of each pixel PX. The transfer transistor TX may be electrically connected to the photoelectric conversion region 410. In addition, a transfer gate TG and a floating diffusion region FD on the active region may be included. The transfer gate TG may include a first portion TGa on the first surface 400a of the first substrate 400 and a second portion TGb extending from the first portion TGa into the first substrate 400. The maximum width of the first portion TGa in the second direction D2 may be greater than the maximum width of the second portion TGb in the second direction D2. The floating diffusion region FD may be adjacent to one side of the transfer gate TG. The floating diffusion region FD may be provided in the active region. The floating diffusion region FD may have a second conductivity type (e.g., an n-type) opposite to that of the first substrate 400. However, the shapes of the transfer gate TG and the floating diffusion region FD illustrated in FIG. 4 are examples, and example embodiments are not limited thereto.

A gate dielectric layer GI may be provided between the transfer gate TG and the first substrate 400. A gate spacer GS may be provided on a sidewall of the transfer gate TG. The gate spacer GS may include silicon nitride, silicon carbide nitride, or silicon oxynitride.

Referring to FIG. 4, the first wire region 20 is provided on the first surface 400a of the first substrate 400 and may include a plurality of insulating layers IL1, IL2, and IL3, a plurality of wire layers CL1 and CL2, and vias VIA.

The insulating layer may include a first insulating layer IL1, a second insulating layer IL2, and a third insulating layer IL3.

The first insulating layer IL1 may cover the first surface 400a of the first substrate 400. The first insulating layer IL1 may cover the gate electrode TG. The second insulating layer IL2 may be provided on the first insulating layer IL1. The third insulating layer IL3 may be provided on the second insulating layer IL2.

The first to third insulating layer (IL1, IL2, and IL3) may include a non-conductive material. For example, the first to third insulating layers (IL1, IL2, and IL3) may include a silicon-based insulating material such as silicon oxide, silicon nitride, or silicon oxynitride.

The first wire region 20 may include a first wire layer CL1 and a second wire layer CL2. The first wire layer CL1 may be provided in the second insulating layer IL2. The second wire layer CL2 may be provided in the third insulating layer IL3.

A plurality of vias VIA may be provided in the first insulating layer IL1, the second insulating layer IL2, and the third insulating layer IL3. The via VIA may connect the floating diffusion region FD, the first wire layer CL1, and the second wire layer CL2 to each other.

The first wire layer CL1, the second wire layer CL2, and the via VIA may include a metal material. For example, the first wire layer CL1, the second wire layer CL2, and the via VIA may include copper Cu.

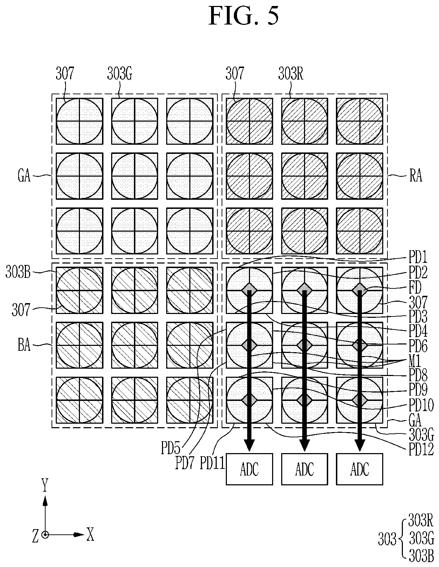

As shown in FIG. 4, the floating diffusion region FD of the first photoelectric conversion element PD1 and the floating diffusion region FD of the second photoelectric conversion element PD2 may be connected to each other. According to example embodiments, the floating diffusion regions FD of 12 photoelectric conversion elements may be connected to one another. Alternatively, the floating diffusion regions FD of nine photoelectric conversion elements may be connected to each other. When the floating diffusion regions FD of the plurality of photoelectric conversion element PD are connected to each other in this way, only the signal of one photoelectric conversion element PD may be output, or the signals of the plurality of photoelectric conversion elements PD may be output at the same time, so that various combinations of signals may be output. A detailed explanation of connecting the photoelectric conversion element will be described later with reference to FIG. 5 to FIG. 16.

The light transmission layer 30 may include an insulation structure 329, a color filter 303, and a microlens unit 306. The light transmission layer 30 may condense and filter light incident from the outside to provide the light to the photoelectric conversion region 410.

A color filter 303 may be provided on the second surface 400b of the first substrate 400. The color filter 303 may be disposed on each of the photoelectric conversion elements PD. For example, the same color filter may be disposed on a plurality of photoelectric conversion elements PD. As will be described separately later, in the image sensor according to an example embodiment, the same color filter may be disposed on 36 photoelectric conversion elements PD. The color filter 303 may include primary color filters. The color filter 303 may include a first color filter, a second color filter, and a third color filter having different colors. For example, the first color filter, the second color filter, and the third color filter may include green, red, and blue color filters, respectively. The first color filter, the second color filter, and the third color filter may be arranged in a Bayer pattern. As another example, the first color filter, the second color filter, and the third color filter may include a color such as cyan, magenta, or yellow.

An insulation structure 329 may be provided between the second surface 400b of the first substrate 400 and the color filter 303. The insulation structure 329 may prevent reflection of light so that light incident on the second surface 400b of the first substrate 400 may smoothly (i.e., evenly) reach the photoelectric conversion region 410. The insulation structure 329 may be referred to as an anti-reflection structure.

The insulation structure 329 may include a first fixed charge layer 321, a second fixed charge layer 323, and a planarization layer 325 sequentially stacked on the second surface 400b of the first substrate 400. Each of the first fixed charge layer 321, the second fixed charge layer 323, and the planarization layer 325 may include different materials. The first fixed charge layer 321 may include any one of aluminum oxide, tantalum oxide, titanium oxide, and hafnium oxide. The second fixed charge layer 323 may include any one of aluminum oxide, tantalum oxide, titanium oxide, and hafnium oxide. For example, the first fixed charge layer 321 may include aluminum oxide, the second fixed charge layer 323 may include hafnium oxide, and the planarization layer 325 may include silicon oxide. In another example embodiment, a silicon anti-reflection layer may be interposed between the second fixed charge layer 323 and the planarization layer 325. The anti-reflection layer may include silicon nitride.

The microlens unit 306 may be provided on the color filter 303. The microlens unit 306 may include a flat portion 305 in contact with the color filter 303 and a microlens 307 provided on the portion 305. The flat portion 305 may include, for example, an organic material. As another example, the flat portion 305 may include silicon oxide or silicon oxynitride. The microlens 307 may have a convex shape to condense light incident on the pixel PX. Each microlens 307 may vertically overlap the photoelectric conversion region 410. The shape of the lens may vary.

As shown in FIG. 4, one microlens 307 may overlap a plurality of photoelectric conversion regions 410 (and in this regard a plurality of pixels PX). However, this is only an example, and the number of microlenses 307 in one pixel PX may vary. A detailed arrangement of the microlens 307 will be described later with reference to FIG. 5 to FIG. 9 and FIG. 21.

The light transmission layer 30 may further include a Bayer pattern 311 and a passivation layer 316. The Bayer patterns 311 may be provided between the color filters 303 adjacent to each other to separate them from each other. The Bayer pattern 311 may be provided on the insulation structure 329. For example, the Bayer pattern 311 may have a grid structure. The Bayer pattern 311 may include a material having a lower refractive index than the color filter 303. The Bayer pattern 311 may include an organic material. For example, the Bayer pattern 311 may be a polymer layer including silica nanoparticles. Because the Bayer pattern 311 has a low refractive index, the amount of light incident on the photoelectric conversion region 410 may be increased, and crosstalk between pixels PX may be reduced. That is, the light-receiving efficiency may be increased in each photoelectric conversion region 410, and the signal noise ratio (SNR) characteristics may be improved.

The passivation layer 316 may cover the surface of the Bayer pattern 311 with a substantially uniform thickness. The passivation layer 316 may include, for example, at least one single layer or multiple layers of an aluminum oxide layer and a silicon carbide oxide layer. The passivation layer 316 may protect the color filter 303 and may function to absorb moisture.

However, the plan view and the cross-sectional view of the image sensor described above are only examples, and example embodiments are not limited thereto. The image sensor according to an example embodiment is characterized in that a plurality of photoelectric conversion elements PD, for example, 12 photoelectric conversion elements PD, or floating diffusion regions FD of nine photoelectric conversion elements PD are connected to each other, and the planar structure and cross-sectional structure of the image sensor may vary depending on the specific connection type.

Hereinafter, a detailed structure of the image sensor according to an example embodiment will be described in detail with reference to the drawings.

FIG. 5 illustrates a plurality of photoelectric conversion elements PD and a plurality of microlenses 307 in the image sensor according to an example embodiment. In FIG. 5, 144 photoelectric conversion elements PD are illustrated, and the same color filters may be disposed on 36 photoelectric conversion elements arranged in 6 columns in the first direction (X direction) and 6 rows in the second direction (Y direction).

Specifically, in FIG. 5, 144 photoelectric conversion elements are shown, and a green color filter 303G is provided on 36 photoelectric conversion elements to form a green color region GA, a red color filter 303R is provided on 36 photoelectric conversion elements to form a red color region RA, a blue color filter 303B is provided on 36 photoelectric conversion elements to form a blue color region BA, and a green color filter 303G is provided on 36 photoelectric conversion elements to form a green color region. That is, referring to FIG. 5, the image sensor according to an example embodiment may include two green color regions GA, a red color region RA, and a blue color region BA, and each color region may include 36 photoelectric conversion elements PD.

Referring to FIG. 5, in the image sensor according to an example embodiment, one microlens 307 may be provided for each of four photoelectric conversion elements PD. That is, each color region may include 36 photoelectric conversion elements and nine microlenses 307. However, the number of such microlenses 307 is an example, and example embodiments are not limited thereto. As in FIG. 5, when one microlens 307 is provided on four photoelectric conversion elements, auto-focus is possible. The photoelectric conversion element PD sharing one microlens 307 has different angles at which light is incident for each photoelectric conversion element, and thus autofocus may be implemented through this. Regarding FIG. 5, because all photoelectric conversion elements PD share the microlens 307 with other photoelectric conversion elements PD, autofocus is possible in all pixels.

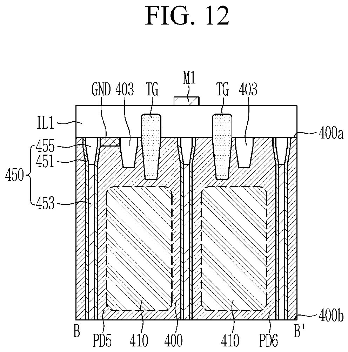

In FIG. 5, 12 photoelectric conversion elements may constitute one pixel circuit. That is, in the image sensor according to an example embodiment, 12 photoelectric conversion elements among 36 photoelectric conversion elements in which the same color filter is provided constitute one pixel and may be connected to one analog digital converter ADC. The analog digital converter may receive a signal generated by each photoelectric conversion element and convert the signal into a digital value. In this case, as shown in FIG. 5, two photoelectric conversion elements may be connected to one analog digital converter (ADC) in the first direction (X direction) and six photoelectric conversion elements in the second direction (Y direction). However, this is an example, and six photoelectric conversion elements may be connected to an analog digital converter (ADC) in the first direction (X direction) and two photoelectric conversion elements in the second direction (Y direction). Therefore, as illustrated in FIG. 5, one of the green color regions GA may include three analog digital converters. The other color regions of FIG. 5 may also include 12 photoelectric conversion elements that are each connected to one analog digital converter, and one color region may include three analog digital converters.

As such, in the image sensor according to an example embodiment, 36 photoelectric conversion elements correspond to the same color filter, and at this point, 12 photoelectric conversion elements are connected to one pixel circuit. Through this, each photoelectric conversion element may output signals individually or the 12 photoelectric conversion elements may collectively output a signal, and noise of the image sensor may be improved.

Hereinafter, specific characteristics will be described. The noise of the image sensor includes pixel noise (SF noise) and ADC noise ADC noise) as follows.

$$\text{SF } noise = \frac{N_{SF}}{\sqrt{\#}}$$

$$\text{ADC } noise = N_{ADC}''$$

In this case, the noise of the image sensor is composed of the sum of pixel noise and ADC noise as follows.

$$Noise = \sqrt{N_{SF}^{2} + N_{ADC}^{2}}$$

In the pixel noise (SF noise), # refers to the number of analog digital converters (ADC) provided for one color region sharing the same color filter. In this regard, 36 photoelectric conversion elements are provided in one color region, and 12 of these 36 photoelectric conversion elements are connected to one analog digital converter (ADC), and three analog digital converters (ADC) exist in one color region. Therefore, # corresponds to 3 in this example.

In addition, the relationship between the number (#) of ADCs and the conversion gain is as follows.

$$\text{Conversion gain} = CG\ /\ \#$$

The total noise of the image sensor corresponds to a value obtained by dividing the noise by the conversion gain

as follows.

$$\text{Total noise} = \text{Noise/CG}$$

As described above, the image sensor may have a sharing structure in which one color filter is provided on 36 photoelectric conversion elements, of which 12 photoelectric conversion elements are connected to each other.

Table 1 below summarizes the relative noise according to the number of ADCs. As shown, if 18 photoelectric conversion elements are connected by one pixel circuit, two ADCs are required and AVG is 2. In addition, if 12 photoelectric conversion elements are connected by one pixel circuit, three ADCs are required and AVG is 3. If 36 photoelectric conversion elements are connected to each other, one ADC is required and AVG is 1.

In this case, the relative values of the conversion gain, pixel noise, ADC noise, and total noise for each case are as follows.

(Table 1)

| | 1 AVG (ref) | Example embodiment 1 (2 AVG) | Example embodiment 2 (3 AVG, 2x6 shared) | Example embodiment 3 (1 AVG, 6x6 shared) |
|---|---|---|---|---|
| CG | 1 | 1/2 | 1/3 | 1/3 |
| SF Noise | 1 | $1/\sqrt{2}$ | $1/\sqrt{3}$ | 1 |
| ADC Noise | 1 | 1 | 1 | 1 |
| Total Noise (Noise/CG) | 1 | 2.44 | 3.46 | 4.24 |

As shown in Table 1, the noise value of Example 2, in which 12 photoelectric conversion elements were connected to each other, was decreased compared to Example 3, in which 36 photoelectric conversion elements were connected to each other. Additionally, it appears that the entire noise value of example embodiment 1 (2 AVG) in which 18 photoelectric conversion elements are connected to one pixel circuit, is lower than the entire noise value of example embodiment 2 (3 AVG) in which the 12 photoelectric conversion elements are connected to one pixel circuit, but connecting 18 photoelectric conversion elements to one pixel circuit requires additional design and manufacturing complexity, due to the structure. When 18 photoelectric conversion elements are connected to one pixel circuit, photoelectric conversion elements that share the same microlens 307 are connected to different pixel circuits, which may increase noise. In addition, the capacitance increases due to the arrangement of wire for connecting 18 photoelectric conversion elements to one pixel circuit, which may increase noise. FIG. 5 illustrates a configuration in which two photoelectric conversion elements are connected to each other in the first direction (X direction) and six photoelectric conversion elements are connected to each other in the second direction (Y direction), but this is an example, and six photoelectric conversion elements may be connected to each other in the first direction (X direction) and two photoelectric conversion elements in the second direction (Y direction).

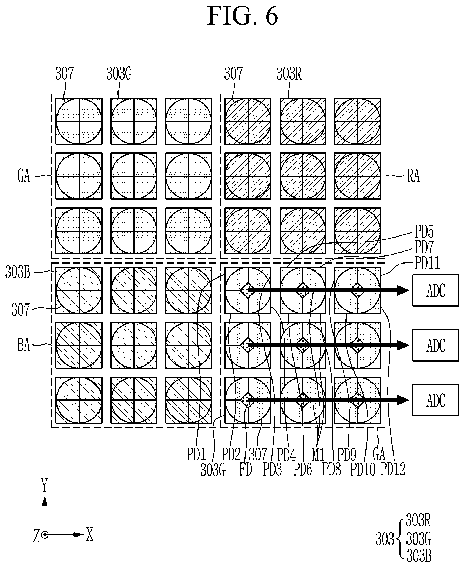

FIG. 6 illustrates a plurality of photoelectric conversion elements PD and a plurality of microlenses 307 in the image sensor according to an example embodiment. Referring to FIG. 6, the image sensor is the same as the image sensor shown in FIG. 5 except that six photoelectric conversion elements in the first direction (X direction) and two in the second direction (Y direction) are connected to a single analog digital converter ADC. A detailed description of the same constituent elements is omitted.

That is, in the image sensor according to an example embodiment, one identical color filter is provided on 36 photoelectric conversion elements, and among them, the floating diffusion region FD of the photoelectric conversion element PD arranged in 2x6 or 6x2 may be connected to each other.

Although FIG. 5 and FIG. 6 illustrate configurations in which the number of microlenses 307 in each of the green color regions GA, the red color region RA, and the blue color region BA is the same, this is only an example and example embodiments are not limited thereto. The number of microlenses 307 in each color region may vary.

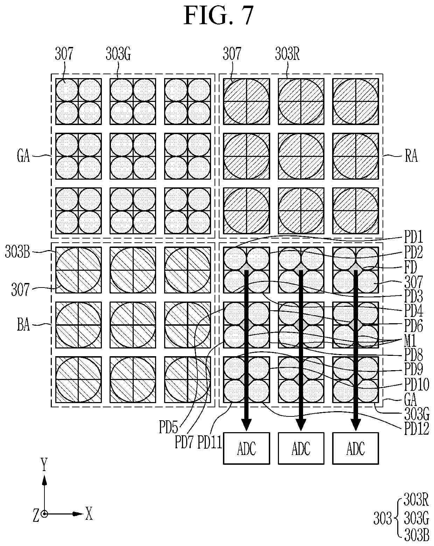

FIG. 7 illustrates a plurality of photoelectric conversion elements PD and a plurality of microlenses 307 in the image sensor according to an example embodiment. Referring to FIG. 7, the image sensor is the same as the image sensor shown in FIG. 5, except that one microlens 307 is provided on each photoelectric conversion element PD in the green color regions GA. A detailed description of the same constituent elements is omitted. As shown in FIG. 7, when one microlens 307 is provided on one photoelectric conversion element PD in the green color regions GA, image quality damage may be prevented. That is, when a plurality of photoelectric conversion elements PD share one microlens 307, there may be image quality deterioration due to image signals mixing. However, as shown in FIG. 7, when one microlens 307 is provided on one photoelectric conversion element PD in the green color regions GA, color loss may be prevented. Because green is the color that has the greatest influence on visibility and image quality, it is possible to prevent image quality degradation in the green color regions GA and to implement auto-focus in the blue color region BA and the red color region RA. As shown in FIG. 7, 12 photoelectric conversion elements PD are connected to each other to form one pixel circuit, and thus noise of the image sensor may be reduced.

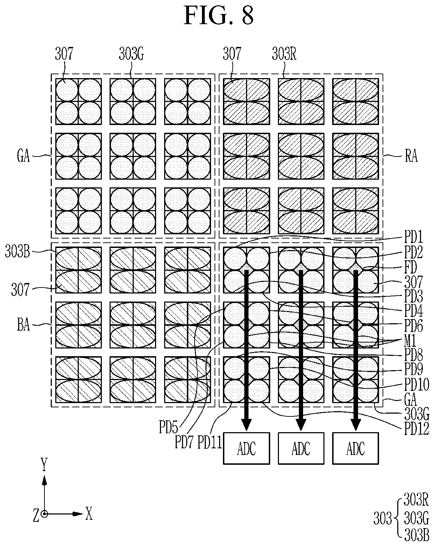

FIG. 8 illustrates a plurality of photoelectric conversion elements PD and a plurality of microlenses 307 in the image sensor according to an example embodiment. Referring to FIG. 8, the image sensor is the same as FIG. 5, except that one microlens 307 is provided on two photoelectric conversion elements in the red color region RA and the blue color region BA. A detailed description of the same constituent elements is omitted. As shown in FIG. 8, 12 photoelectric conversion elements are connected to each other to form one pixel circuit, and thus noise may be reduced.

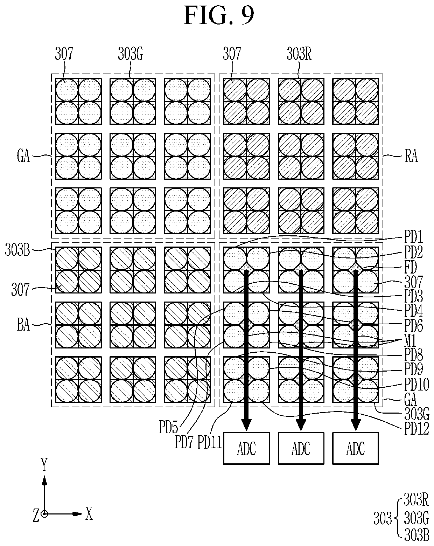

FIG. 9 illustrates a plurality of photoelectric conversion elements PD and a plurality of microlenses 307 in the image sensor according to an example embodiment. Referring to FIG. 9, the image sensor is the same as the image sensor shown in FIG. 5 except that one microlens 307 is provided on one photoelectric conversion element PD in the green color region GA, the red color region RA, and the blue color region BA. A detailed description of the same constituent elements is omitted. When one microlens 307 is provided on one photoelectric conversion element PD in all color regions as shown in FIG. 9, color deterioration may be prevented, and image quality may be improved. As shown in FIG. 9, 12 photoelectric conversion elements are connected to each other to form one pixel circuit, and thus noise may be reduced.

However, the arrangement of the microlens 307 described with reference to FIG. 5 to FIG. 9 is merely an example, and example embodiments are not limited thereto. The microlens 307 may be disposed in various shapes in addition to the shapes illustrated in FIG. 5 to FIG. 9.

Hereinafter, a detailed arrangement in which floating diffusion regions of 12 photoelectric conversion elements are connected to each other in the image sensor will be described. However, the structure and arrangement described below are only examples, and the connection of the photoelectric conversion element PD is not limited to the shape described below.

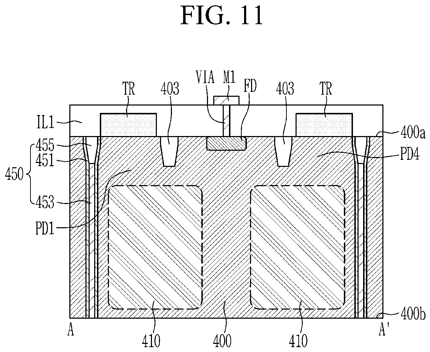

FIG. 10 schematically illustrates planar shapes of 12 photoelectric conversion elements in an image sensor according to an example embodiment. FIG. 11 is a cross-sectional view illustrating FIG. 10 cut along the line A-A', and FIG. 12 is a cross-sectional view illustrating FIG. 10 cut along the line B-B'. For convenience of description, only some components of the image sensor are shown in FIG. 10 to FIG. 12. The description of the light transmission layer 30 and the first wire region 20 is the same as described above with reference to FIG. 4. Also, for convenience of explanation, FIG. 11 and FIG. 12 are shown oppositely to FIG. 4 and up and down. That is, in FIG. 4, the first surface 400a is shown as below, but in the following drawings, the first surface 400a is provided above.

Referring to FIG. 10, a pixel separation pattern 450 on a plane may be provided around the first photoelectric conversion element PD1, the second photoelectric conversion element PD2, the third photoelectric conversion element PD3, and the fourth photoelectric conversion element PD4. However, as shown in FIG. 10 and FIG. 11, the pixel separation pattern 450 may not completely separate the first photoelectric conversion element PD1, the second photoelectric conversion element PD2, the third photoelectric conversion element PD3, and the fourth photoelectric conversion element PD4. For example the first photoelectric conversion element PD1, the second photoelectric conversion element PD2, the third photoelectric conversion element PD3, and the fourth photoelectric conversion element PD4 may be connected to each other in a central portion. That is, as shown in FIG. 11, the first substrate 400 of the first photoelectric conversion element PD1, the second photoelectric conversion element PD2, the third photoelectric conversion element PD3, and the fourth photoelectric conversion element PD4 may be connected to each other.

The description of the pixel separation pattern 450 is the same as that described above. That is, the pixel separation pattern 450 may include a first separation pattern 451, a second separation pattern 453, and a capping pattern 455. However, this is an example, and the shape of the pixel separation pattern 450 is not limited thereto.

The device separation pattern 403 may be provided in the first substrate 400. As illustrated in FIG. 10, the device separation pattern 403 may define an active region ACT, and an upper surface of the device separation pattern 403 may be provided in the first substrate 400. The width of the device separation pattern 403 may gradually decrease from the first surface 400a to the second surface 400b of the first substrate 400. An upper surface of the device separation pattern 403 may be vertically spaced apart from the photoelectric conversion region 410. The description of the device separation pattern 403 is the same as that described above. A detailed description of the same constituent elements is omitted.

The gate electrode TG of the transfer transistor may be provided on the active region ACT. Although FIG. 12 briefly illustrates the configuration of the gate electrode (TG) for convenience of explanation, the same contents of the gate electrode TG described in FIG. 4 may be applied.

The description of the photoelectric conversion region 410 is the same as that described above. That is, the photoelectric conversion region 410 may generate and accumulate electric charges according to the amount of received light. The photoelectric conversion region 410 may constitute the photoelectric conversion element PD.

The photoelectric conversion region 410 may be a region doped with impurity of a second conductivity type in the first substrate 400. The second conductivity type impurity may have a conductivity type opposite to the first conductivity type impurity. The second conductivity type impurities may include n-type impurities such as phosphorus, arsenic, bismuth, or antimony. For example, each photoelectric conversion region 410 may include a first region adjacent to the first surface 400a and a second region adjacent to the second surface 400b. There may be a difference in impurity concentration between the first region and the second region of the photoelectric conversion region 410. Accordingly, the photoelectric conversion region 410 may have a potential slope between the first surface 400a and the second surface 400b of the first substrate 400. As another example, the photoelectric conversion region 410 may not have a potential slope between the first surface 400a and the second surface 400b of the first substrate 400.

The first substrate 400 and the photoelectric conversion region 410 may constitute a photodiode. That is, a photodiode may be configured by a p-n junction between the first substrate 400 of the first conductivity type and the photoelectric conversion region 410 of the second conductivity type. The photoelectric conversion region 410 constituting the photodiode may generate and accumulate photo charges in proportion to the intensity of incident light.

As shown in FIG. 10 to FIG. 12, the transistor TR may be provided in the active region ACT. The transistor TR may be at least one of a conversion transistor, a source follower transistor, and a selection transistor for driving the image sensor. For example, the transistor TR shown in FIG. 10 may be a source follower transistor. However, this is an example, and some transistors that make up the pixel circuit are provided in the active region ACT, some transistors are provided on other substrates, and can be connected through the floating diffusion region FD. This will be described later separately with reference to FIG. 26.

Referring to FIG. 10 to FIG. 12, a floating diffusion region FD is provided at a position where four photoelectric conversion elements PD1, PD2, PD3, and PD4 are connected to each other. The floating diffusion region FD may be a region in which the first substrate 400 is doped with an impurity of a second conductivity type opposite to the impurity of the first conductivity type.

As shown in FIG. 10, one floating diffusion region FD is provided between four photoelectric conversion elements PD, and thus three floating diffusion regions FD may be provided for 12 photoelectric conversion elements PD. The three floating diffusion regions FD may be connected to each other through a via VIA and a first wire M1. Accordingly, the floating diffusion regions FD of the twelve photoelectric conversion elements PD are connected to each other. This has the effect of reducing the noise of the image sensor as described above.

Also, referring to FIG. 10 and FIG. 12, a ground region GND is provided on the active region ACT. The ground region GND is a region to which a ground voltage is applied and may be a region in which the first substrate 400 is doped with impurities of a first conductivity type. Because the four photoelectric conversion elements PD share one first substrate 400, one ground region GND may be provided in the four photoelectric conversion elements PD.

As described above with reference to FIG. 10 to FIG. 12, the first substrate 400 constituting the first photoelectric conversion element PD1, the second photoelectric conversion element PD2, the third photoelectric conversion element PD3, and the fourth photoelectric conversion element PD4 are not separated but connected to each other, and there is a floating diffusion region FD in the connection region. That is, there is one floating diffusion region FD per four photoelectric conversion elements PD, and 12 photoelectric conversion elements PD are connected to each other through three floating diffusion regions FD. As described above, this has the effect of reducing the noise of the image sensor. Although the four photoelectric conversion elements PD1, PD2, PD3, and PD4 have been described above as an example, the description of the other photoelectric conversion elements PD5, PD6, PD6, PD7, PD8, PD9, PD10, PD11, and PD12 is also the same.

However, this configuration is an example, and the first substrate 400 constituting the first photoelectric conversion element PD1, the second photoelectric conversion element PD2, the third photoelectric conversion element PD3, and the fourth photoelectric conversion element PD4 may be separated by the pixel separation pattern 450. In this case, the neighboring first photoelectric conversion element PD1, the second photoelectric conversion element PD2, the third photoelectric conversion element PD3, and the fourth photoelectric conversion element PD4 may each include a floating diffusion region FD, and each of these floating diffusion regions FD may be connected through a separate pad.

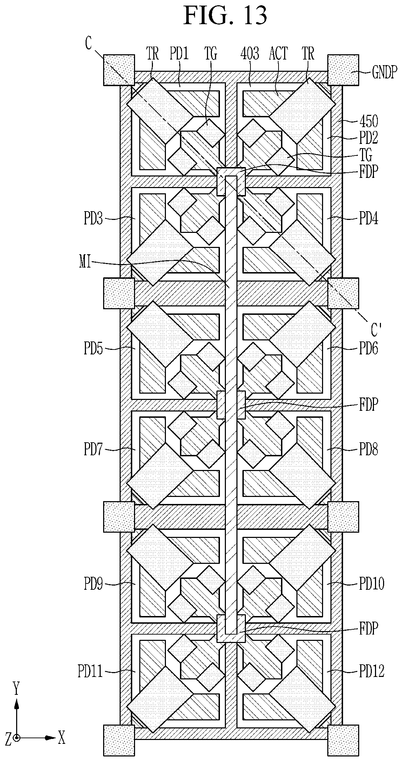

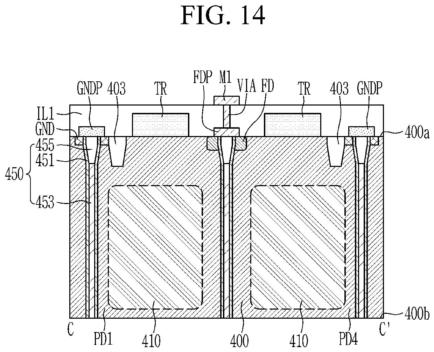

FIG. 13 illustrates planar shapes of 12 photoelectric conversion elements in an image sensor according to an example embodiment. FIG. 14 is a cross-sectional view taken along the line C-C' of FIG. 13. Referring to FIG. 13 and FIG. 14, in the image sensor, the first photoelectric conversion element PD1, the second photoelectric conversion element PD2, the third photoelectric conversion element PD3, and the fourth photoelectric conversion element PD4 are separated by the pixel separation pattern 450. Therefore, a separate connection pad FDP is provided to connect the floating diffusion region FD in the active region ACT of each photoelectric conversion element. In addition, a separate ground connection pad GNDP is provided to simultaneously supply ground voltages to the ground region GND in each photoelectric conversion element.

Referring to FIG. 13 and FIG. 14, a connection pad FDP for connecting the floating diffusion regions FD in each photoelectric conversion element PD is provided. Therefore, the floating diffusion regions FD in each photoelectric conversion element PD may be connected to each other through these pads. As illustrated in FIG. 13, the connection pad FDP may be connected to each other through the first wire M1, and the floating diffusion regions FD of 12 photoelectric conversion elements PD1, PD2, PD3, PD4, PD5, PD6, PD7, PD8, PD9, PD10, PD11, and PD12 may be connected to each other. The connection pad FDP may include polycrystalline silicon but is not limited thereto.

In addition, as shown in FIG. 13 and FIG. 14, the ground region GND may be provided at the corner of each photoelectric conversion element. Therefore, the ground connection pad GNDP is provided in the position where the ground region GND gathers, and the same ground voltage can be applied to multiple photoelectric conversion elements. Descriptions of the other components with respect to FIG. 13 and FIG. 14 are the same as those described in FIG. 10 to FIG. 12, and thus will be omitted. The ground connection pad GNDP may also include polycrystalline silicon.

That is, in FIG. 10 to FIGS. 12, the first substrates 400 of the four photoelectric conversion elements PD are connected to each other, and a ground voltage may be applied to the four photoelectric conversion elements with one ground pad. In addition, because the first substrates of the four photoelectric conversion elements PD are connected to each other, the four photoelectric conversion elements PD may share one floating diffusion region FD. Accordingly, in order to connect the 12 photoelectric conversion elements PD each other, the three floating diffusion regions FD are connected through the first wire M1 or the like.

However, in FIG. 13 and FIG. 14, the first substrate of the first photoelectric conversion element PD1, the second photoelectric conversion element PD2, the third photoelectric conversion element PD3, and the fourth photoelectric conversion element PD4 is separated by the pixel separation pattern 450. Therefore, a separate connection pad FDP is provided to connect the floating diffusion region FD of each photoelectric conversion element, and by connecting the connection pad FDP through the first wire M1, 12 photoelectric conversion elements PD1, PD2, PD3, PD4, PD5, PD5, PD6, PD7, PD8, PD9, PD10, PD11, and PD12 may be connected to each other. In addition, a separate ground connection pad GNDP connecting the ground region GND of each photoelectric conversion element PD1, PD2, PD3, PD4, PD5, PD6, PD7, PD8, PD9, PD10, PD11, and PD12 can be used to apply a ground voltage to each photoelectric conversion element.

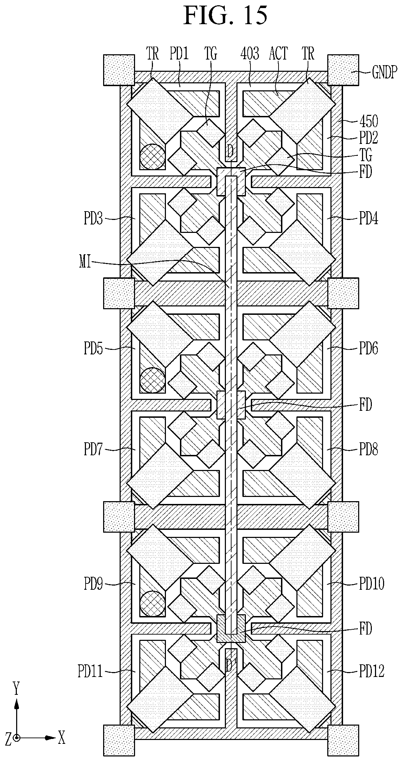

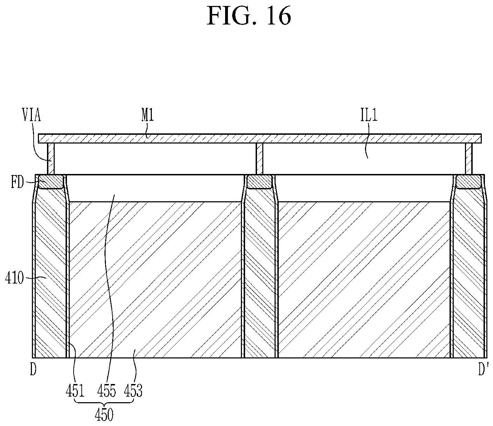

In addition, a structure in which configurations shown in FIG. 10 to FIG. 12 may be combined (i.e., mixed) with configurations shown in FIG. 13 and FIG. 14 are also possible. FIG. 15 illustrates planar shapes of 12 photoelectric conversion elements in an image sensor according to an example embodiment. FIG. 16 is a cross-sectional view taken along the line D-D' of FIG. 15. Referring to FIG. 15, as in FIG. 10, the image sensor has the first substrate of the first photoelectric conversion element PD1, the second photoelectric conversion element PD2, the third photoelectric conversion element PD3, and the fourth photoelectric conversion element PD4 connected to each other. Thus, the first photoelectric conversion element PD1, the second photoelectric conversion element PD2, the third photoelectric conversion element PD3, and the fourth photoelectric conversion element PD4 share one floating diffusion region FD. Therefore, as shown in FIG. 15 and FIG.16, three floating diffusion regions FD shared by the four photoelectric conversion elements PD1, PD2, PD3, and PD4 may be connected to each other by connecting the first wire M1. However, as shown in FIG. 15, the ground region GND may apply a voltage at a time using a ground connection pad GNDP that connects the ground regions provided in each photoelectric conversion element each other, as in FIG. 13 and FIG. 14. That is, FIG. 15 and FIG. 16 correspond to a combination of FIG. 10 to FIG. 12 and FIG. 13 and FIG. 14.

However, this arrangement and connection form are only examples, and example embodiments are not limited thereto. The main feature of the present disclosure is that 12 photoelectric conversion elements are connected to each other, and a specific connection method may be different according to an example embodiment.

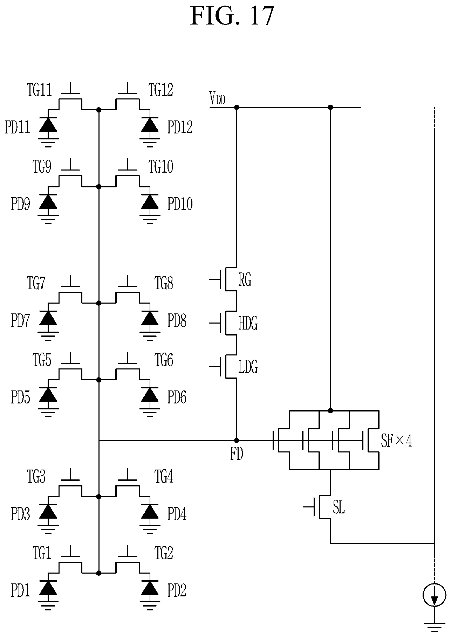

Hereinafter, a circuit diagram of an image sensor according to an example embodiment will be described. However, the circuit diagram described below is only an example, and example embodiments are not limited thereto. FIG. 17 is a circuit diagram of a pixel included in an image sensor according to example embodiments. The 12 photoelectric conversion elements PD1, PD2, PD3, PD4, PD5, PD6, PD7, PD8, PD9, PD10, PD11, and PD12 constitute one pixel.

Referring to FIG. 17, one pixel may include a plurality of photoelectric conversion elements PD1, PD2, PD3, PD4, PD5, PD6, PD7, PD8, PD9, PD10, PD11, and PD12. Each of the photoelectric conversion elements PD1, PD2, PD3, PD4, PD5, PD6, PD7, PD8, PD9, PD10, PD11, and PD12 may perform photoelectric conversion. As shown in FIG. 17, a plurality of photoelectric conversion elements PD1, PD2, PD3, PD4, PD5, PD6, PD7, PD8, PD9, PD10, PD11, and PD12 may be connected to each other.

Hereinafter, the first photoelectric conversion element PD1 is mainly described, but the following description is equally applied to other photoelectric conversion elements PD1, PD2, PD3, PD4, PD5, PD6, PD7, PD8, PD9, PD10, PD11, and PD12.

The first photoelectric conversion element PD1 may generate and accumulate electric charges according to the amount of received light. The first photoelectric conversion element PD1 may include an anode connected to the ground and a cathode connected to one end of the first transfer transistor TG1. A first transmission signal may be supplied to the gate of the first transfer transistor TG1, and one end of the first transfer transistor TG1 may be connected to the floating diffusion region FD. When the first transfer transistor TG1 is turned on by the first transmission signal, charges charged in the first photoelectric conversion element PD1 may be transferred to the floating diffusion region FD. The floating diffusion region FD may maintain electric charges transferred from the photoelectric conversion element PD.

Each of a plurality of transfer transistors TG1, TG2, TG3, TG4, TG5, TG6, TG7, TG8, TG9, TG10, TG11, and TG12 is connected between one of a plurality of photoelectric conversion elements PD1, PD2, PD3, PD4, PD5, PD6, PD7, PD8, PD9, PD10, PD11, and TG12 and a floating diffusion region FD, and may include a gate electrode receiving a plurality of transmission signals. For example, the first transfer transistor TG1 may include a gate electrode connected between the first photoelectric conversion element PD1 and the floating diffusion region FD and receiving a first transmission signal.

The number of a plurality of transfer transistors TG1, TG2, TG3, TG4, TG5, TG6, TG7, TG8, TG9, TG10, TG11, and TG12 may be equal to the number of a plurality of photoelectric conversion elements PD1, PD2, PD3, PD4, PD5, PD6, PD7, PD8, PD9, PD10, PD11, and PD12.

A plurality of conversion transistors RG, HDG, and LDG may be connected between the power supply voltage VDD and the floating diffusion region FD.

The conversion transistors RG, HDG, and LDG may periodically reset charges accumulated in the floating diffusion region FD. When the conversion transistors RG, HDG, and LDG are turned on, a power supply voltage VDD connected to a source electrode of the conversion transistors RG, HDG, and LDG may be applied to the floating diffusion region FD. Therefore, when the conversion transistors RG, HDG, and LDG are turned on, charges accumulated in the floating diffusion region FD may be discharged and the floating diffusion region FD may be reset.

In addition, the image sensor may include a plurality of conversion transistors RG, HDG, and LDG. Therefore, the capacity of the floating diffusion region may be expanded by using some of the plurality of conversion transistors RG, HDG, and LDG. That is, various combinations may be derived by turning on or off some of the plurality of conversion transistors RG, HDG, and LDG, and the capacity of the floating diffusion region may be extended to various combinations. For example, conversion transistors RG and HRG may be controlled to be off, while conversion transistor LDG is turned on. For example, conversion transistor RG may be controlled to be off, while conversion transistors HDG and LDG are turned on.

Accordingly, a signal may be received through a combination of various photoelectric conversion elements among 12 photoelectric conversion elements connected to each other. All signals of a plurality of transfer transistors TG1, TG2, TG3, TG4, TG5, TG6, TG7, TG8, TG9, TG10, TG11, and TG12 may be received, or only some signals may be received. The required capacitance varies depending on the number of transistors received at this time, and at this time, some of the plurality of conversion transistors RG, HDG, and LDG can be used to expand the capacity of the floating diffusion region, and signals can be received without loss for various combinations.

The source follower transistor SF may output a pixel signal according to a voltage of the floating diffusion region FD. The gate of the source follower transistor SF may be connected to the floating diffusion region FD, the power supply voltage VDD may be supplied to the source electrode of the source follower transistor SF, and the drain electrode of the source follower transistor SF may be connected to one end of the selection transistor SL. The source follower transistor SF may output a voltage having a level corresponding to the charge accumulated in the floating diffusion region FD as a pixel signal. As shown in FIG. 17, the circuit of the image sensor may reduce noise by connecting four source follower transistors SF in parallel. However, this is only an example, and the image sensor according to an example embodiment may include one source follower transistor SF.

When the selection transistor SL is turned on by the selection signal, a pixel signal of the source follower transistor SF may be transmitted to the readout circuit. A selection signal may be applied to the gate electrode of the selection transistor SL, and the drain electrode of the selection transistor SL may be connected to an output wire outputting a plurality of pixel signals.

An operation of the image sensor will be described below with reference to FIG. 17. First, while the light is blocked (i.e., while a shutter of a camera including the image sensor is closed), a power supply voltage VDD is applied to the drain electrode of the conversion transistors (RG, HDG, LDG) and the drain electrode of the source follower transistor SF, and the conversion transistor conversion transistors (RG, HDG, LDG) are turned on to emit charges remaining in the floating diffusion region FD. Then, when the conversion transistors (RG, HDG, LDG) are turned off and light from the outside is incident on the photoelectric conversion elements (PD1, PD2, PD3, PD4, PD5, PD6, PD7, PD8, PD9, PD10, PD11, PD12), electron-hole pairs are generated in each of the photoelectric conversion elements (PD1, PD2, PD3, PD4, PD4, PD5, PD6, PD7, PD8, PD9, PD10, PD11, PD12), respectively. Holes are moved to and accumulated in the p-type impurity region of the photoelectric conversion elements (PD1, PD2, PD3, PD4, PD5, PD6, PD7, PD8, PD9, PD10, PD11, PD12), and electrons are moved to and accumulated in the n-type impurity region. When the transfer transistors (TG1, TG2, TG3, TG4, TG5, TG6, TG7, TG8, TG9, TG10, TG11, TG12) are turned on, charges such as electrons and holes are transferred to and accumulated in the floating diffusion region FD. The gate bias of the source follower transistor SF is changed in proportion to the accumulated amount of electric charge, resulting in a change in the source potential of the source follower transistor SF. At this time, when the selection transistor SL is turned on, a signal by the electric charge is read through the output wire.

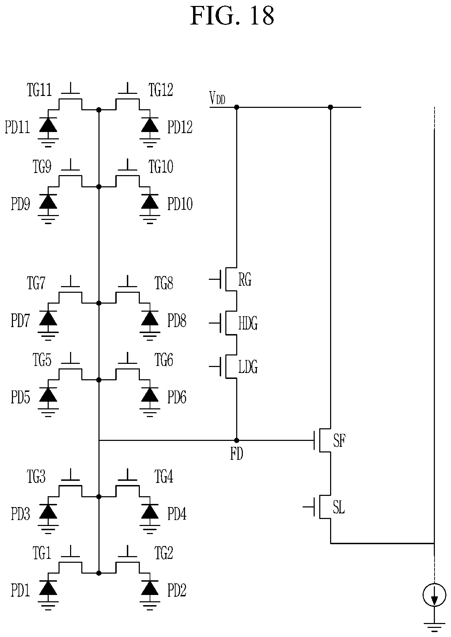

FIG. 18 is a circuit diagram of a pixel included in an image sensor according to another example embodiment. FIG. 18 is the same as an example embodiment of FIG. 17, except that it includes one source follower transistor SF. A detailed description of the same constituent elements is omitted.

FIGS. 17 and 18 illustrate circuit diagrams including three conversion transistors, four selection transistors, and 12 photoelectric conversion elements, but the image sensor according to example embodiments is not be limited thereto.

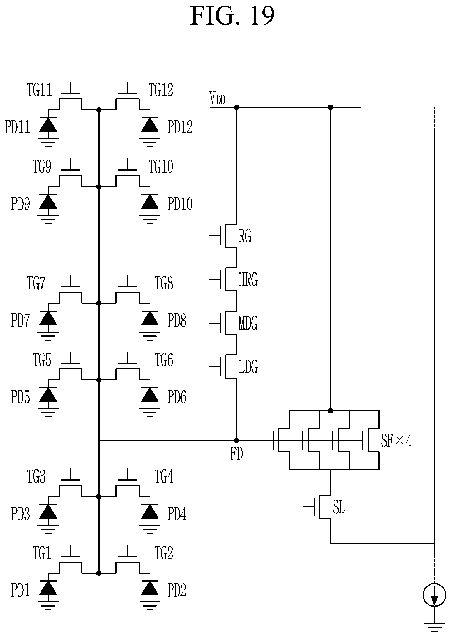

FIG. 19 is a circuit diagram of a pixel included in an image sensor according to another example embodiment. Referring to FIG. 19, the image sensor is the same as an embodiment of FIG. 17, except that the image sensor includes four conversion transistors RG, HRG, MDG and LDG. A detailed description of the same constituent elements is omitted. FIG. 19 includes four conversion transistors RG, HRG, MDG and LDG. Accordingly, the capacity of the floating diffusion region FD may be expanded in various combinations compared to FIG. 17. For example, conversion transistors RG, HRG, MDG and LDG may be controlled to be off, while conversion transistor LDG is turned on. For example, conversion transistors RG and HRG may be controlled to be off, while conversion transistors MDG and LDG are turned on. For example, conversion transistors RG may be controlled to be off, while conversion transistors HRG, MDG and LDG are turned on.

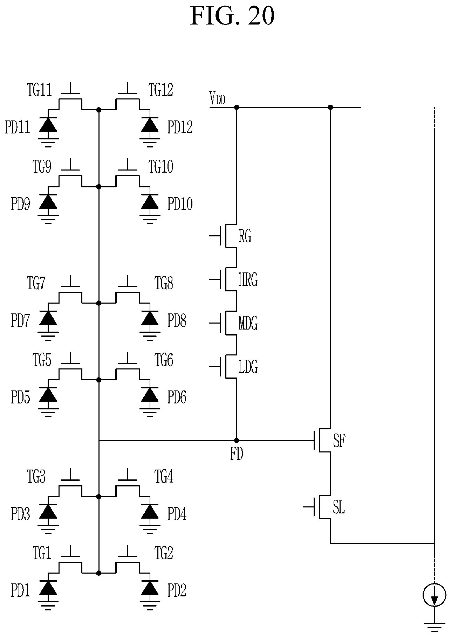

Also, FIG. 20 is a circuit diagram of a pixel included in an image sensor according to another example embodiment. FIG. 20 is the same as FIG. 19, except that one source follower transistor SF is included. A detailed description of the same constituent elements is omitted.

As describe above, an example embodiment in which 12 photoelectric conversion elements constitute one circuit has been described, but in another example embodiment, nine photoelectric conversion elements may constitute one circuit. Hereinafter, another example embodiment will be described.

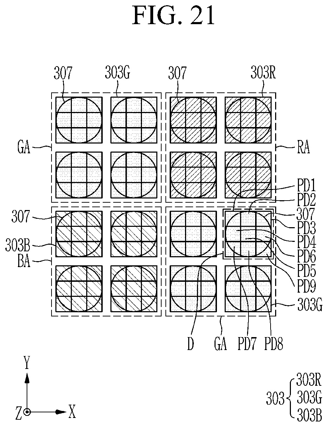

FIG. 21 illustrates a plurality of photoelectric conversion elements PD and a plurality of microlenses 307 in the image sensor according to an example embodiment. Referring to FIG. 21, FIG. 21 is different from FIG. 5 in that one microlens 307 is provided for each of nine photoelectric conversion elements PD. A detailed description of the same constituent elements is omitted.

In FIG. 21, color filters of green, red and blue may be provided in each of the photoelectric conversion elements PD. In FIG. 5, 144 photoelectric conversion elements are shown, and one color filter having the same color may be provided on the 36 photoelectric conversion elements PD. That is, in the image sensor according an example embodiment, the same color filter may be provided on 36 photoelectric conversion elements arranged in six columns in the first direction X and six rows in the second direction Y A green color filter 303G is provided on 36 photoelectric conversion elements among the 144 photoelectric conversion elements shown in FIG. 21 to form a green color region GA, a red color filter 303R is provided on 36 photoelectric conversion elements to form a red color region RA, a blue color filter 303B is provided on 36 photoelectric conversion elements to form a blue color region BA, and a green color filter 303G is provided on 36 photoelectric conversion elements to form another green color region GA.

That is, referring to FIG. 21, the image sensor according to an example embodiment may include a green color region GA, a red color region RA, a blue color region BA, and another green color region GA. Each color region may include 36 photoelectric conversion elements PD and four microlenses 307.

In FIG. 21, photoelectric conversion elements constituting one pixel circuit are shown by dotted lines and D. In an example embodiment of FIG. 21, nine photoelectric conversion elements (PD1, PD2, PD3, PD4, PD5, PD6, PD7, PD8, PD9) arranged in three columns in the first direction X and three rows in the second direction Y may constitute a single pixel circuit. Although only a part of the photoelectric conversion elements shown in FIG. 21 are shown, nine photoelectric conversion elements may constitute one pixel circuit in the same manner as other photoelectric conversion elements shown in FIG. 21.

Although FIG. 21 illustrates a configuration in which the number of microlenses 307 provided in each of the green color regions GA, the red color region RA, and the blue color region BA is the same, this is only an example, but example embodiments are not limited thereto. The number of microlenses 307 provided in each color region may vary.

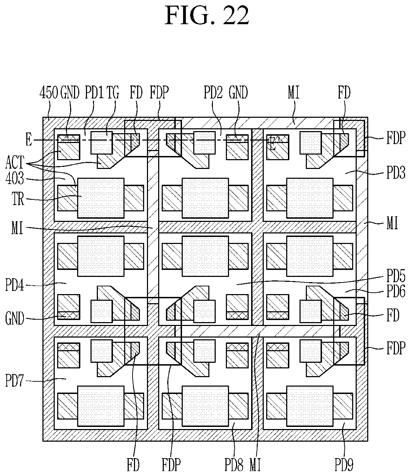

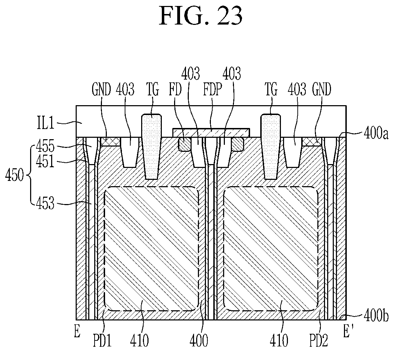

FIG. 22 is a plan view illustrating nine photoelectric conversion elements in an image sensor according to an example embodiment. FIG. 23 is a cross-sectional view illustrating FIG. 20 taken along the line E-E'. Referring to FIG. 22, each of the photoelectric conversion elements PD1, PD2, PD3, PD4, PD5, PD6, PD7, PD8, and PD9 is divided into a pixel separation pattern 450. The description of the pixel separation pattern 450 is the same as that described above. That is, the pixel separation pattern 450 may include a first separation pattern 451, a second separation pattern 453, and a capping pattern 455. However, this is an example, and the shape of the pixel separation pattern 450 is not limited thereto.

The device separation pattern 403 may be provided in the first substrate 400. As shown in FIG. 22 and FIG. 23, the device separation pattern 403 may define an active region ACT, and an upper surface of the device separation pattern 403 may be provided in the first substrate 400. The width of the device separation pattern 403 may gradually decrease from the first surface 400a to the second surface 400b of the first substrate 400. An upper surface of the device separation pattern 403 may be vertically spaced apart from the photoelectric conversion region 410. The description of the device separation pattern 403 is the same as that described above. A detailed description of the same constituent elements is omitted.

The gate electrode TG of the transfer transistor may be provided on the active region ACT.

The description of the photoelectric conversion region 410 is the same as that described above. That is, the photoelectric conversion region 410 may generate and accumulate electric charges according to the amount of received light. The photoelectric conversion region 410 may constitute the photoelectric conversion element PD.

The photoelectric conversion region 410 may be a region doped with impurity of a second conductivity type in the first substrate 400. The second conductivity type impurity may have a conductivity type opposite to the first conductivity type impurity. The second conductivity type impurities may include n-type impurities such as phosphorus, arsenic, bismuth, or antimony. For example, each photoelectric conversion region 410 may include a first region adjacent to the first surface 400a and a second region adjacent to the second surface 400b. There may be a difference in impurity concentration between the first region and the second region of the photoelectric conversion region 410. Accordingly, the photoelectric conversion region 410 may have a potential slope between the first surface 400a and the second surface 400b of the first substrate 400. As another example, the photoelectric conversion region 410 may not have a potential slope between the first surface 400a and the second surface 400b of the first substrate 400.

The first substrate 400 and the photoelectric conversion region 410 may constitute a photodiode. That is, a photodiode may be configured by a p-n junction between the first substrate 400 of the first conductivity type and the photoelectric conversion region 410 of the second conductivity type. The photoelectric conversion region 410 constituting the photodiode may generate and accumulate photo charges in proportion to the intensity of incident light.

As shown in FIG. 22, the transistor TR may be provided in the active region ACT. The transistor TR may be one of a conversion transistor, a source follower transistor, and a selection transistor for driving an image sensor. For example, the transistor TR shown in FIG. 22 may be a source follower transistor. However, this is an example, and only a part of the transistor for driving the image sensor is provided in the active region ACT, some transistors are provided on other substrates, and can be connected through the floating diffusion region FD. This will be described later separately with reference to FIG. 26.

As shown in FIGS. 22 and 23, nine photoelectric conversion elements (PD1, PD2, PD3, PD4, PD5, PD6, PD7, PD8, PD9) include each floating diffusion region FD. The floating diffusion region FD may be a region in which the first substrate 400 is doped with a second conductivity type opposite to the first conductivity type impurity. Each of the floating diffusion regions FD may be connected to each other through the connection pad FDP and the first wire M1. Accordingly, nine photoelectric conversion elements (PD1, PD2, PD3, PD4, PD5, PD6, PD7, PD8, PD9) are connected as one. This has the effect of reducing noise as described above.

Also, referring to FIG. 22 and FIG. 23, a ground region GND is provided on the active region ACT. The ground region GND is a region to which a ground voltage is applied and may be a region to which the first substrate 400 is doped with a first conductivity type. The ground regions GND of each photoelectric conversion element PD may be connected to each other each other.

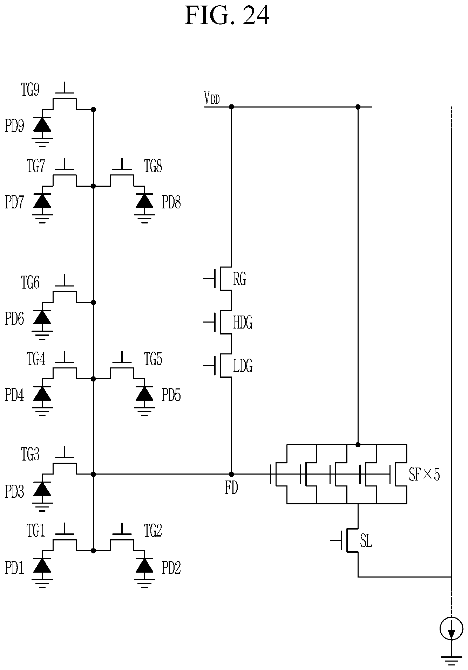

FIG. 24 is a circuit diagram of a pixel included in an image sensor according to example embodiments. In an example embodiment, the nine photoelectric conversion elements (PD1, PD2, PD3, PD4, PD5, PD6, PD7, PD8, PD9) constitute one pixel. The circuit diagram according to an example embodiment of FIG. 24 is the same as FIG. 17, except that it includes nine photoelectric conversion elements instead of 12 photoelectric conversion elements and 5 source follower transistors SF. A detailed description of the same constituent elements is omitted.

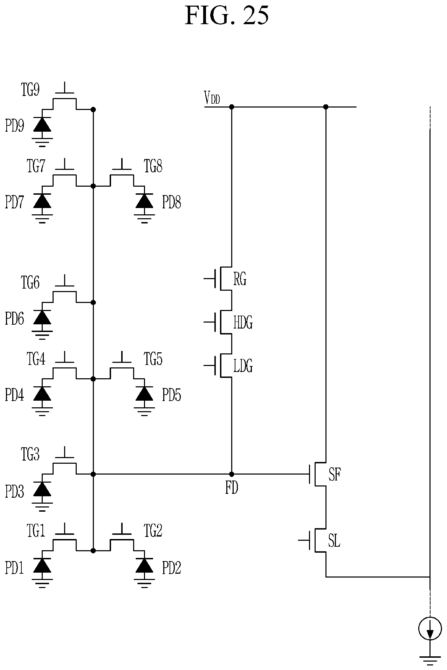

FIG. 25 is a circuit diagram of a pixel included in an image sensor according to another example embodiment. FIG. 25 is the same as FIG. 24, except that one source follower transistor SF is included. A detailed description of the same constituent elements is omitted.

In the above, some components of the image sensor, particularly, the first chip 1000, have been mainly described. Hereinafter, a structure including the second chip 2000 and the third chip 3000 will be described. At least one of a conversion transistor, a source follower transistor, and a selection transistor of the image sensor according may be provided in the second chip 2000.

FIG. 26 is a cross-sectional view of an image sensor according to an example embodiment.

FIG. 26 illustrates an image sensor according to an example embodiment, and may include a first chip 1000, a second chip 2000, and a third chip 3000. The first chip 1000 may include a photoelectric conversion layer 10, a first wire region 20, and a light transmission layer 30. The photoelectric conversion layer 10 may include a first substrate 400, a pixel separation pattern 450, a device separation pattern 403, and a photoelectric conversion region 410 provided in the first substrate 400. Light incident from the outside may be converted into an electrical signal in the photoelectric conversion region 410.

The first chip 1000 includes a photoelectric conversion layer 10 and is a layer that generates a photoelectric signal, and the second chip 2000 may be a layer in which transistors such as conversion transistors RG, HDG, and LDG, source follower transistors SF and selection transistors SL, and wire connected to each transistor are provided. A logic circuit may be provided in the third chip 3000. The description of the first chip 1000 is the same as that described above with reference to FIG. 3 and FIG. 4, and thus will be omitted.

Referring to FIG. 26, a fourth insulating layer IL4 may be provided on the third insulating layer IL3. The first floating diffusion region connection node FDCN_1 may be provided in the fourth insulating layer IL4. The first floating diffusion region connection node FDCN_1 may include a main connection portion FDCN_1A and a shielding portion FDCN_1B. The shielding portion FDCN_1B may be provided at an edge of the main connection portion FDCN_1A and may be provided in an area narrower than that of the main connection portion FDCN_1A. The shielding portion FDCN_1B may prevent interference between the floating diffusion region connection node of the neighboring pixel PX. The main connection portion FDCN_1A of the first floating diffusion region connection node FDCN_1 is connected to wires of the first wire layer CL1 and the second wire layer CL2, but the shielding portion FDCN_1B of the first floating diffusion region connection node FDCN_1 may not be connected to the wire of the first wire layer CL1 and the wire of the second wire layer CL2. In addition, the main connection portion FDCN_1A of the first floating diffusion region connection node FDCN_1 is provided in a separate island shape for each pixel, but the shielding portion FDCN_1B may be provided connected to neighboring pixels. For example, the shielding portion FDCN_1B may be provided in a linear shape extending in one direction on a plane. A separate voltage may be applied to the shielding portion FDCN_1B. However, the configuration of the main connection portion FDCN_1A and the shielding portion FDCN_1B is only an example, and the shape of the first floating diffusion region connection node FDCN_1 is not limited thereto. For example, the first floating diffusion region connection node FDCN_1 may include only a main connection portion FDCN_1A.

As shown in FIG. 26, one surface of the first floating diffusion region connection node FDCN_1 is exposed without being covered with the fourth insulating layer IL4. Therefore, as will be described later, it can contact the second floating diffusion region connection node FDCN_2 provided in the second chip 2000.

The second chip 2000 will be described. The second chip 2000 may include a second substrate 500, a second wire region 40, and a third wire region 70.

The second substrate 500 may include a first surface 500a and a second surface 500b opposite each other. The second wire region 40 may be provided on the first surface 500a of the second substrate 500, and the third wire region 70 may be provided on the second surface 500b of the second substrate 500.

The second substrate 500 may be a semiconductor substrate or a silicon on insulator SOI substrate. The semiconductor substrate may include, for example, a silicon substrate, a germanium substrate, or a silicon-germanium substrate. The second substrate 500 may include a first conductivity type impurity. For example, the impurities of the first conductivity type may include p-type impurities such as aluminum Al, boron B, indium In, or gallium Ga.

The first surface 500a of the second substrate 500 may be provided to face the first surface 400a of the first substrate 400.

A fifth insulating layer IL5, a sixth insulating layer IL6, a seventh insulating layer IL7, a third wire layer CL3, a plurality of vias VIA, and a second floating diffusion region connection node FDCN_2 may be provided on the first surface 500a of the second substrate 500.

The fifth insulating layer IL5, the sixth insulating layer IL6, and the seventh insulating layer IL7 may include a non-conductive material. For example, the fifth insulating layer IL5, the sixth insulating layer IL6, and the seventh insulating layer IL7 may include a silicon-based insulating material such as silicon oxide, silicon nitride, or silicon oxynitride.

The third wire layer CL3, the via VIA, and the second floating diffusion region connection node FDCN_2 may include a metallic material. For example, the third wire layer CL3, the via VIA, and the second floating diffusion region connection node FDCN_2 may include copper Cu.

The third wire layer CL3 may be provided in the sixth insulating layer IL6. The wire of the third wire layer CL3 and the transistor TR may be connected through a via VIA. In this case, the transistor TR may be at least one of the above-described conversion transistors RG, HDG, and LDG, the source follower transistor SF, and the selection transistor SL.

The second floating diffusion region connection node FDCN_2 may be provided in the seventh insulating layer IL7. The second floating diffusion region connection node FDCN_2 may include a main connection portion FDCN_2A and a shielding portion FDCN_2B. The shielding portion FDCN_2B may be provided at an edge of the main connection portion FDCN_2A and may be provided in an area narrower than that of the main connection portion FDCN_2A. The shielding portion FDCN_2B may prevent interference between the floating diffusion region connection node of the neighboring pixel. The main connection portion FDCN_2A of the second floating diffusion region connection node FDCN_2 is connected to the wire of the third wire layer CL3, but the shielding portion FDCN_2B of the second floating diffusion region connection node FDCN_2 may not be connected to the wire of the third wire layer CL3. The main connection portion FDCN_2A of the second floating diffusion region connection node FDCN_2 is provided in an island shape separated for each pixel, but the shielding portion FDCN_2B may be provided to be connected to neighboring pixels. For example, the shielding portion FDCN_2B may be provided in a linear shape extending in one direction on a plane. A separate voltage may be applied to the shielding portion FDCN_2B. However, the configuration of the main connection portion FDCN_2A and the shielding portion FDCN_2B is only an example, and the shape of the second floating diffusion region connection node FDCN_2 is not limited thereto. For example, the second floating diffusion region connection node FDCN_2 may include only main connection portion FDCN_2A.

As shown in FIG. 26, one surface of the second floating diffusion region connection node FDCN_2 is exposed without being covered with a seventh insulating layer IL7. Therefore, as shown in FIG. 26, the first floating diffusion region connection node FDCN_1 provided in the first chip 1000 and the second floating diffusion region connection node FDCN_2 provided in the second chip 2000 may contact each other.

Referring to FIG. 26, the second chip 2000 may include a deep node DN penetrating the second substrate 500. The deep node DN may include a metal, for example, copper Cu. However, these materials are only examples, and may also contain other metallic materials.

The deep node DN is extends through the second substrate 500, and one end of the deep node DN may be provided on the first surface 500a and the other end may be provided on the second surface 500b. In the present specification, the expression provided on a certain surface is not limited to being provided in contact with the surface but includes being provided in a form that is not in contact with or protruding from the surface. That is, as shown in FIG. 26, one end of the deep node DN may be provided to protrude from the first surface 500a, and the other end may be provided to protrude from the second surface 500b.

Therefore, as shown in FIG. 26, one end of the deep node DN may be in contact with the wire of the third wire layer CL3. In addition, the other end of the deep node DN may be in contact with the fourth wire layer CL4 provided on the second surface 500b of the second substrate 500.

An eighth insulating layer IL8, a ninth insulating layer IL9, a tenth insulating layer IL10, a fourth wire layer CL4, a fifth wire layer CL5, and a via VIA may be provided on the second surface 500b of the second substrate 500.

The eighth insulating layer IL8, the ninth insulating layer IL9, and the tenth insulating layer IL10 may include a non-conductive material. For example, the eighth insulating layer IL8, the ninth insulating layer IL9, and the tenth insulating layer IL10 may include a silicon-based insulating material such as silicon oxide, silicon nitride, or silicon oxynitride.

The fourth wire layer CL4, the fifth wire layer CL5, and the via VIA may include a metallic material. For example, the fourth wire layer CL4, the fifth wire layer CL5, and the via VIA may include copper Cu. However, these materials are only examples, and example embodiments are not limited thereto.

The fourth wire layer CL4 may be provided in the ninth insulating layer IL9. The fifth wire layer CL5 may be provided in the tenth insulating layer IL10. The fourth wire layer CL4 and the fifth wire layer CL5 may be connected through a via VIA.

The deep node DN may be provided on the fifth insulating layer IL5, the second substrate 500, and the eighth insulating layer IL8. The deep node DN may be provided to penetrate the second substrate 500 and may connect one or more of the transistors provided on the first surface 500a of the second substrate 500 to the fourth wire layer CL4 and the fifth wire layer CL5 provided on the second surface 500b of the second substrate 500.

The second chip 2000 may be connected to the third chip 3000. The third chip 3000 may include a third substrate 700 and a fourth wire region 80. A transistor constituting a logic circuit may be provided on the first surface 700a of the third substrate 700, and a plurality of wires LCL may be provided in the fourth wire region 80. The fourth wire region 80 may include an insulating film LIL, and a plurality of wires LCL may be connected to the wire of the second chip 2000 through a via.

In the image sensor, at least one of the conversion transistors RG, HDG, and LDG, the source follower transistor SF, and the selection transistor SL may be provided on the first surface 500a of the second substrate 500, and at least one of the wires connected to the conversion transistors RG, HDG, and LDG, the source follower transistor SF, and the selection transistor SL may be provided on the second surface 500b of the second substrate 500. The conversion transistors RG, HDG, and LDG, the source follower transistor SF, and the selection transistor SL and the wire may be connected through a deep node DN penetrating the second substrate 500.

As described above, because each transistor and wire are provided on different surfaces, the length of the floating diffusion region connected between the first chip 1000 and the second chip 2000 may be shortened. That is, in FIG. 26, when the fourth wire layer CL4 and the fifth wire layer CL5 are provided on the first surface 500a of the second substrate 500, the distance between the first surface 400a of the first substrate 400 and the first surface 500a of the second substrate 500 is increased as much as the thickness of the fourth wire layer CL4, the fifth wire layer CL5 and the insulating layer for insulating them. However, the image sensor according to example embodiments may reduce the distance between the first surface 400a of the first substrate 400 and the first surface 500a of the second substrate 500 because the fourth wire layer CL4 and the fifth wire layer CL5 are provided on the second surface 500b of the second substrate 500. Accordingly, the length connecting the floating diffusion region FD in the first chip 1000 and the second chip 2000 may be shortened, and the conversion gain CG may be improved.

However, this is only an example, and the conversion transistors RG, HDG, and LDG, the source follower transistor SF, and the selection transistor SL may be provided on the second surface 500b of the second substrate 500. In this case, the deep node DN may not be included.

In addition, the fourth wire layer CL4 and the fifth wire layer CL5 may be provided on the first surface 500a of the second substrate 500, and in this case, the deep node DN may not be included.

As described above, in the image sensor according to example embodiments, one color filter is provided on 36 photoelectric conversion elements, and floating diffusion regions of 12 photoelectric conversion elements or nine photoelectric conversion elements are connected to form one pixel circuit and one analog digital converter. In this regard, 36 photoelectric conversion elements where the same color filter is provided are connected to three analog digital converters or four analog digital converters, which can output various pixel signals and reduce noise.

In some embodiments, each of the components represented by a block as illustrated in FIG. 1 may be implemented as various numbers of hardware and/or firmware structures that execute respective functions described above, according to example embodiments. For example, at least one of these components may include various hardware components including a digital circuit, a programmable or non-programmable logic device or array, an application specific integrated circuit (ASIC), transistors, capacitors, logic gates, or other circuitry using use a direct circuit structure, such as a memory, a processor, a logic circuit, a look-up table, etc., that may execute the respective functions through controls of one or more microprocessors or other control apparatuses. Also, at least one of these components may further include or may be implemented by a processor such as a central processing unit (CPU) that performs the respective functions, a microprocessor, or the like. Functional aspects of example embodiments may be implemented in algorithms that execute on one or more processors. Furthermore, the components, elements, modules or units represented by a block or processing steps may employ any number of related art techniques for electronics configuration, signal processing and/or control, data processing and the like.

**Claims**

1. An image sensor (100) comprising:

   a first substrate (400) comprising a first surface (400a) and a second surface (400b) opposite each other, and a plurality of photoelectric conversion elements (PD) between the first surface (400a) and the second surface (400b); and
   a color filter provided on the second surface (400b) of the first substrate (400) and comprising a first color filter (303G), a second color filter (303R), and a third color filter (303B),
   wherein the first color filter (303G) is provided on 36 photoelectric conversion elements among the plurality of photoelectric conversion elements (PD),
   wherein the 36 photoelectric conversion elements are arranged in six columns extending in a first direction (X) and in six rows extending in a second direction (Y) that crosses the first direction (X), and
   wherein floating diffusion regions (FD) of 12 photoelectric conversion elements among the 36 photoelectric conversion elements are connected to each other.

2. The image sensor (100) of claim 1, wherein each of the second color filter (303R) and the third color filter (303B) is provided on 36 of the plurality of photoelectric conversion elements (PD).

3. The image sensor (100) of claim 1 or 2, wherein the 12 photoelectric conversion elements are arranged in two columns extending in the first direction (X) and six rows extending in the second direction (Y).

4. The image sensor (100) of claim 1 or 2, wherein the 12 photoelectric conversion elements are arranged in six columns extending in the first direction (X) and two rows extending in the second direction (Y).

5. The image sensor (100) of any one of claims 1 to 4, further comprising a pixel separation pattern (450), wherein the 12 photoelectric conversion elements are separated into groups of four by the pixel separation pattern (450).

6. The image sensor (100) of claim 5, wherein the first substrates (400) of four photoelectric conversion elements among the 12 photoelectric conversion elements are connected to each other.

7. The image sensor (100) of any one of claims 1 to 4, wherein the 12 photoelectric conversion elements are separated by a pixel separation pattern (450) one by one.

8. The image sensor (100) of claim 7, wherein the floating diffusion regions (FD) provided in each of the 12 photoelectric conversion elements are connected to each other through a connection pad (FDP).

9. The image sensor (100) of any one of claims 1 to 8, wherein the floating diffusion regions (FD) of the 12 photoelectric conversion elements are electrically connected to at least three conversion transistors (RG, HDG, LDG) and one or more source follower transistors (SF).

10. The image sensor (100) of any one of claims 1 to 9, further comprising one microlens (307) provided on four photoelectric conversion elements among the 36 photoelectric conversion elements.

11. The image sensor (100) of any one of claims 1 to 10, further comprising one microlens (307) provided on one photoelectric conversion element among the 36 photoelectric conversion elements.

12. The image sensor (100) of any one of claim 1 to 11, further comprising one microlens (307) provided on two photoelectric conversion elements among the 36 photoelectric conversion elements.

13. The image sensor (100) of any one of claims 1 to 12, further comprising:

a second substrate (500) overlapping the first substrate (400); and

a transistor provided on the second substrate (500),

wherein the transistor provided on the second substrate (500) is electrically connected to the floating diffusion regions (FD).

14. An image sensor (100) comprising:

a substrate comprising a first surface (400a) and a second surface (400b) opposite each other, and a plurality of photoelectric conversion elements (PD) between the first surface (400a) and the second surface (400b); and

a color filter provided on the second surface (400b) of the substrate and comprising a first color filter (303G), a second color filter (303R), a third color filter (303B) and a fourth color filter (303G), the first color filter (303G) and the fourth color filter (303G) corresponding to a common color,

wherein a first color region (GA) of the image sensor (100) comprises the first color filter (303G), 36 photoelectric conversion elements, among the plurality of photoelectric conversion elements (PD), are grouped into three groups, each of the three groups comprising 12 photoelectric conversion elements arranged in six columns extending in a first direction (X) and two rows extending in a second direction (Y), wherein for each of the three groups, floating diffusion regions (FD) of the 12 photoelectric conversion elements are configured to be commonly connected,

wherein a second color region (RA) of the image sensor (100) comprises the second color filter (303R), 36 photoelectric conversion elements, among the plurality of photoelectric conversion elements (PD), are grouped into three groups, each of the three groups comprising 12 photoelectric conversion elements arranged in six columns extending in the first direction (X) and two rows extending in the second direction (Y), wherein for each of the three groups, floating diffusion regions (FD) of the 12 photoelectric conversion elements are configured to be commonly connected,

wherein a third color region (BA) of the image sensor (100) comprises the third color filter (303B) is provided on 36 photoelectric conversion elements, among the plurality of photoelectric conversion elements (PD), are grouped into three groups, each of the three groups comprising 12 photoelectric conversion elements arranged in six columns extending in the first direction (X) and two rows extending in the second direction (Y), wherein for each of the three groups, floating diffusion regions (FD) of the 12 photoelectric conversion elements are configured to be commonly connected, and

wherein a fourth color region (GA) of the image sensor (100) comprises the fourth color filter (303G) is provided on 36 photoelectric conversion elements, among the plurality of photoelectric conversion elements (PD), are grouped into three groups, each of the three groups comprising 12 photoelectric conversion elements arranged in six columns extending in the first direction (X) and two rows extending in the second direction (Y), wherein for each of the three groups, floating diffusion regions (FD) of the 12 photoelectric conversion elements are configured to be commonly connected.

15. The image sensor (100) of claim 14, further comprising nine microlenses (307) provided in the first color region (GA), nine microlenses (307) provided in the second color region (RA), nine microlenses (307) provided in the third color region (BA), and nine microlenses (307) provided in the fourth color region (GA).

# FIG. 1

# FIG. 2

FIG. 3

# FIG. 4

# FIG. 5

# FIG. 6

# FIG. 7

# FIG. 8

# FIG. 9

# FIG. 10

# FIG. 11

# FIG. 12

## FIG. 13

# FIG. 14

# FIG. 15

## FIG. 16

# FIG. 17

FIG. 18

# FIG. 19

# FIG. 20

# FIG. 21

# FIG. 22

# FIG. 23

FIG. 24

FIG. 25

# FIG. 26

| | **EUROPEAN SEARCH REPORT** | **Application Number** |
|---|---|---|
| Europäisches Patentamt / European Patent Office / Office européen des brevets | | EP 24 21 6061 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/360175 A1 (DAI TIEJUN [US] ET AL) 18 November 2021 (2021-11-18) * paragraphs [0030], [0041] - [0053]; figures 1-12 * | 1-15 | INV. H10F39/15 H10F39/18 H10F39/00 H04N25/704 |
| A | US 2022/377267 A1 (LIM JUNGWOOK [KR] ET AL) 24 November 2022 (2022-11-24) * figures 2-4, 9-11 * | 1-15 | |
| A | US 2013/088621 A1 (HAMADA MASATAKA [KR]) 11 April 2013 (2013-04-11) * figures 1-22 * | 1-15 | |

| | |
|---|---|
| | **TECHNICAL FIELDS SEARCHED (IPC)** |
| | H10F H04N |

The present search report has been drawn up for all claims

| Place of search | Date of completion of the search | Examiner |
|---|---|---|
| The Hague | 29 April 2025 | Cabrita, Ana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 6061

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | | Publication date | Patent family member(s) | | Publication date |
|---|---|---|---|---|---|
| US 2021360175 | A1 | 18-11-2021 | CN | 113675228 A | 19-11-2021 |
| | | | CN | 113676682 A | 19-11-2021 |
| | | | TW | 202205843 A | 01-02-2022 |
| | | | TW | 202209869 A | 01-03-2022 |
| | | | US | 2021358994 A1 | 18-11-2021 |
| | | | US | 2021360175 A1 | 18-11-2021 |
| US 2022377267 | A1 | 24-11-2022 | CN | 115379142 A | 22-11-2022 |
| | | | KR | 20220156332 A | 25-11-2022 |
| | | | US | 2022377267 A1 | 24-11-2022 |
| | | | US | 2024098384 A1 | 21-03-2024 |
| | | | US | 2025097598 A1 | 20-03-2025 |
| US 2013088621 | A1 | 11-04-2013 | CN | 103037161 A | 10-04-2013 |
| | | | KR | 20130038035 A | 17-04-2013 |
| | | | US | 2013088621 A1 | 11-04-2013 |

EPO FORM P0459

For more details about this annex : see Official Journal of the European Patent Office, No. 12/82